(19) Europäisches Patentamt / European Patent Office / Office européen des brevets

(11) **EP 4 387 133 A1**

(12) **EUROPEAN PATENT APPLICATION**
published in accordance with Art. 153(4) EPC

(43) Date of publication:
**19.06.2024 Bulletin 2024/25**

(21) Application number: **22860333.8**

(22) Date of filing: **17.08.2022**

(51) International Patent Classification (IPC):
**H04L 1/00** *(2006.01)*

(52) Cooperative Patent Classification (CPC):
**H04L 1/00**

(86) International application number:
**PCT/CN2022/112907**

(87) International publication number:
**WO 2023/024987 (02.03.2023 Gazette 2023/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **24.08.2021 CN 202110971999**

(71) Applicant: **Huawei Technologies Co., Ltd.**
**Shenzhen, Guangdong 518129 (CN)**

(72) Inventors:
• **WANG, Xianbin**
**Shenzhen, Guangdong 518129 (CN)**
• **ZHANG, Huazi**
**Shenzhen, Guangdong 518129 (CN)**
• **TONG, Jiajie**
**Shenzhen, Guangdong 518129 (CN)**
• **LI, Rong**
**Shenzhen, Guangdong 518129 (CN)**
• **WANG, Jun**
**Shenzhen, Guangdong 518129 (CN)**

(74) Representative: **Goddar, Heinz J.**
**Boehmert & Boehmert**
**Anwaltspartnerschaft mbB**
**Pettenkoferstrasse 22**
**80336 München (DE)**

(54) **ENCODING AND DECODING METHODS, AND COMMUNICATION APPARATUS**

(57)    This application provides an encoding method, a decoding method, and a communication apparatus. The communication apparatus may obtain an information bit sequence, where a length of the information bit sequence is K; determine a length K1 of a first sequence based on K or M, where M is a quantity of modulation symbols; obtain a first vector based on K, K1, and a predefined sequence, where a length of the first vector is 2JM, M is the quantity of modulation symbols, J is a modulation order, the first vector indicates J coding sub-blocks, the J coding sub-blocks separately belong to a first-type sub-block or a second-type sub-block, the first-type sub-block includes at least one coding sub-block, and the second-type sub-block includes at least one coding sub-block; determine frozen bit locations in the first-type sub-block and information bit locations in the second-type sub-block; and encode the information bit sequence based on the frozen bit locations in the first-type sub-block, the information bit locations in the second-type sub-block, and the first vector. This implementation can reduce coding complexity.

FIG. 4

**Description**

**CROSS-REFERENCE TO RELATED APPLICATIONS**

This application claims priority to Chinese Patent Application No. 202110971999.4, filed with the China National Intellectual Property Administration on August 24, 2021 and entitled "ENCODING METHOD, DECODING METHOD, AND COMMUNICATION APPARATUS", which is incorporated herein by reference in its entirety.

**TECHNICAL FIELD**

Embodiments of this application relate to the field of communication technologies, and in particular, to an encoding method, a decoding method, and a communication apparatus.

**BACKGROUND**

In recent years, as a polar (polar) code is included in a 5th generation (5th generation, 5G) wireless communication standard, design of a polar code modulation scheme also becomes a hot topic in communication research. In a higher-order modulation technology, a plurality of codeword bits are mapped to a same modulation symbol to improve spectral efficiency. In higher-order modulation, different modulation symbols correspond to different energy. Sending more low-energy modulation symbols and less high-energy modulation symbols can save average energy. For a white Gaussian noise channel, when distribution of transmitted modulation symbols complies with Gaussian distribution, an amount of information transmitted per unit energy is the largest.

To make transmitted modulation symbols conform to Gaussian distribution, a probabilistic shaping technology is introduced. Currently, in an online construction algorithm that can be based on density evolution, reliability of each sub-channel needs to be calculated on line. Implementation complexity is high. In addition, there is a polar-based offline construction method, to be specific, based on a given sequence, information bits and frozen bits are sequentially read from the sequence. However, this method cannot adapt to a requirement of polar code construction in which probabilistic shaping is introduced.

**SUMMARY**

This application provides an encoding method, a decoding method, and a communication apparatus, to improve coding efficiency.

According to a first aspect, this application provides an encoding method and a decoding method. The encoding method may be performed by a sending apparatus, and the decoding method may be performed by a receiving apparatus. The sending apparatus may be user equipment (user equipment, UE), a vehicle-mounted device, a terminal device, a module (for example, a chip) in the terminal device, or the like. The sending apparatus may alternatively be a transmission reception point (transmission reception point, TRP), a 5G base station (gNodeB, gNB), a network device, a module (for example, a chip) in the network device, or the like. The receiving apparatus may be the same as the foregoing sending apparatus. Details are not described herein. However, the sending apparatus and the receiving apparatus are different communication apparatuses. For example, the sending apparatus is a terminal device, and the receiving apparatus may be a network device. This is not specifically limited in this application.

The sending apparatus may obtain an information bit sequence, where a length of the information bit sequence is K; and determine a length K1 of a first sequence based on K or M, where M is a quantity of modulation symbols, and K, K1, and M are positive integers. The sending apparatus may obtain a first vector based on K, K1, and a predefined sequence, where a length of the first vector is 2JM, M is the quantity of modulation symbols, J is a modulation order, M and J are positive integers, the first vector indicates J coding sub-blocks, the J coding sub-blocks separately belong to a first-type sub-block or a second-type sub-block, the first-type sub-block includes at least one coding sub-block, and the second-type sub-block includes at least one coding sub-block; determine frozen bit locations in the first-type sub-block and information bit locations in the second-type sub-block; and encode the information bit sequence based on the frozen bit locations in the first-type sub-block, the information bit locations in the second-type sub-block, and the first vector.

Correspondingly, when the receiving apparatus performs the decoding method, the receiving apparatus may obtain a to-be-decoded sequence (the to-be-decoded sequence may be understood as a scrambled encoded sequence because interference or the like may exist when an encoded sequence obtained through encoding by the sending apparatus is transmitted on a channel between the sending apparatus and the receiving apparatus); determine K and M (values of K and M may be obtained by using indication signaling, where the indication signaling may be uplink control information (uplink control information, UCI), downlink control information (downlink control information, DCI), or the like, or may be agreed upon with the sending apparatus in advance, and is not specifically limited herein), where K is a length of an information bit sequence, and M is a quantity of modulation symbols; determine K1 based on K or M, where K, K1, and M are positive integers; obtain a first vector based on K, K1, and a predefined sequence, where a length of the first vector is 2JM, J is a modulation order, J is a positive integer, the first vector indicates J coding sub-blocks, the J coding sub-blocks separately belong to a first-type sub-block or a second-type sub-block, the first-type sub-block includes at least one coding sub-block, and the second-type sub-block includes at least one coding sub-block; determine frozen bit locations in the first-type sub-block and information bit locations in the second-type sub-block; and decode the to-be-decoded sequence based on the frozen bit locations in the first-type sub-block, the information bit locations in the second-type sub-block, and the first vector, to obtain the information bit sequence whose length is K.

It should be noted that the encoding method provided in this application may be applied to higher-order modulation, for example, 64 quadrature amplitude modulation (quadrature amplitude modulation, QAM), 256QAM, or 1024QAM. The information bit sequence may be understood as a sequence that requires coding processing, or may be understood as a to-be-encoded sequence. An information bit sequence length (that is, the length) is determined, and the length of the information bit sequence is K. To improve robustness and reduce complexity during encoding, the information bit sequence may be divided into the first sequence and a second sequence, and different coding processing is performed for different sequences. In actual application, if shaping is introduced during encoding, the first sequence may be understood as a sequence for shaping. Certainly, in actual application, another encoding operation (an operation different from conventional polar coding) may be introduced, and the first sequence may be a sequence for another encoding operation. This is not specifically limited in this application.

In addition, the predefined sequence may be understood as a sequence that meets a mother code length (a sequence length meets $2^N$, where N is a positive integer), for example, a sequence whose length is 8: [1, 2, 3, 5, 4, 6, 7, 8]; or may be understood as another sequence, for example, a sequence pre-agreed upon by the sending apparatus and the receiving apparatus. This is not specifically limited in this application.

It should be noted that, when an encoding operation is performed, a modulation scheme (for example, the modulation scheme is 64QAM higher-order modulation), the modulation order J being 3 ( $r=\log_2(\sqrt{64})=3$ ), and the quantity M of modulation symbols (the quantity of modulation symbols may be preset, for example, agreed upon by the sending apparatus and the receiving apparatus) need to be determined, to construct the first vector whose length is 2JM based on K, K1, the predefined sequence, the modulation order, and the quantity of modulation symbols. A location of the information bit sequence corresponding to the first vector may be determined based on the first vector (for example, if the information bit sequence is [0 1 0], and the first vector is [0 0 0 0 0 1 1 1], the information bit sequence may correspond to 111 in the first vector. In this case, when an encoding operation is performed, the 6th, the 7th, and the 8th locations may be set as information bit locations, and other locations may be set as frozen bit locations). In addition, the information bit locations and the frozen bit locations may be determined by using the first vector, and an encoding operation may be efficiently performed based on the obtained frozen bit locations and the obtained information bit locations.

In addition, the first vector may indicate the J coding sub-blocks, the J coding sub-blocks separately belong to the first-type sub-block or the second-type sub-block, the first-type sub-block includes at least one coding sub-block, and the second-type sub-block may include at least one coding sub-block. Because another encoding operation such as a shaping operation may be introduced during encoding, the first-type sub-block may be understood as a shaping sub-block. To ensure that a decoder, that is, the receiving apparatus, can more quickly obtain the information bit sequence through decoding when another encoding operation is introduced, the information bit sequence may be encoded based on the frozen bit locations in the first-type sub-block, the information bit locations in the second-type frozen bit, and the first vector, to improve decoding efficiency of the decoder.

When an encoding operation is performed in this application, a solution (that is, online coding) of adjusting a coding policy based on a channel status is not used. Instead, the first vector is constructed based on the length of the information bit sequence, the length of the first sequence, and the predefined sequence, different coding sub-blocks are indicated based on the first vector, and the information bit sequence is encoded based on information bit locations and frozen bit locations in the different coding sub-blocks and the first vector. In this way, encoding efficiency can be improved, and calculation complexity is reduced compared with online coding.

In an optional implementation, the sending apparatus or the receiving apparatus may determine a first index set $\Theta$ based on K, K1, and the predefined sequence, and obtain the first vector based on the first index set $\Theta$, where a location index i in the first vector satisfies:

if $i \in \Theta$, the location i carries a first preset value; and

if $i \notin \Theta$ , the location i carries a second preset value, where the first preset value is different from the second preset value, $1 \leq i \leq 2JM,$ and i is a positive integer.

After the first index set is determined based on K, K1, and the predefined sequence, the first vector is obtained based on the first index set. In this way, information bit locations and check bit locations can be directly obtained, thereby reducing coding construction complexity.

In an optional implementation, the first preset value is 1, and the second preset value is 0; or the first preset value is 0, and the second preset value is 1. This is not specifically limited herein in this application. Usually, the first preset value indicates a location of the information bit sequence.

In an optional implementation, an element carried at a $(2M(y - 1) + 1)^{th}$ location in the first vector to an element carried at a $(2My)^{th}$ location in the first vector correspond to a $y^{th}$ coding sub-block, $1 \leq y \leq J$, and y is a positive integer. In other words, lengths of the coding sub-blocks indicated by the first vector are all 2M.

In an optional implementation, the sending apparatus may select F information bit locations from the information bit locations in the second-type sub-block, where F is a length of frozen bits in the first-type sub-block, and F is an integer; and assign values of the F frozen bit locations in the first-type sub-block to the F information bit locations in the second-type sub-block.

It should be noted that, assigning the values of the F frozen bits in the first-type sub-block to the F information bit locations in the second-type sub-block may be understood as directly duplicating the values of the F frozen bit locations in the first-type sub-block to the information bit locations in the second-type sub-block, or may be understood as assigning the values of the F frozen bit locations in the first-type sub-block to the information bit locations in the second-type sub-block through encoding (scrambling, exclusive OR, or the like). In actual application, a value assignment manner is not specifically limited in this application.

In addition, in actual application, the length of the frozen bits in the first-type sub-block may alternatively be F1 (if a length of all frozen bits in the first-type sub-block is 5, F1 may be 3 or another value less than 5), and F2 information bit locations may be selected from the information bit locations in the second-type sub-block. A value of F2 may be different from that of F1. This is not specifically limited herein in this application, provided that a relationship between the frozen bits of the first-type sub-block and information bits of the second-type sub-block may be determined. The relationship between the frozen bits of the first-type sub-block and the second-type information bits is determined, to help the receiving apparatus perform decoding more quickly.

In an optional implementation, the sending apparatus may perform shaping mapping and polar transform on the first sequence to obtain a third sequence; extract a fourth sequence from the third sequence based on the first vector, where an element in the fourth sequence is a value of an information bit location in the first-type sub-block, and a length of the fourth sequence is less than a length of the third sequence; perform cyclic redundancy check (cyclic redundancy check, CRC) calculation on a fifth sequence to obtain a sixth sequence, where the fifth sequence includes a second sequence and the fourth sequence; and encode the sixth sequence.

It should be noted that, decoding performance can be improved by introducing CRC.

In an optional implementation, the sending apparatus or the receiving apparatus may determine K1 in the following manner:

> manner 1: determining K1 based on an index value corresponding to K or M; or
> manner 2:
>
> determining K1 by using the following formula:

$$K1 = \left\lfloor \log_2 C_{2M}^{\lfloor 2Mp_{bias} \rfloor} \right\rfloor,$$

> where
>
> K1 represents a length of a first sequence, M represents the quantity of modulation symbols, and $p_{bias}$ represents a preset shaping probability.

It should be noted that, determining K1 in the manner 1 is simpler, and has a smaller calculation amount. In the manner 2, K1 is determined based on the quantity of modulation symbols and the preset shaping probability. Compared with the manner 1, in the manner 2, a calculation amount is increased, but reliability is higher and flexibility is higher.

In an optional implementation, the sending apparatus or the receiving apparatus may determine a first parameter T based on K and K1, and select T sequence elements from the predefined sequence to construct the first index set Θ.

In this implementation, information bit locations and check bit locations can be directly obtained, thereby reducing coding construction complexity.

In an optional implementation, the sending apparatus or the receiving apparatus may determine T in the following manner:

manner 1:

$$T = 2M + K - K1,$$

where
T represents the first parameter, M represents the quantity of modulation symbols, K represents the length of the information bit sequence, and K1 represents the length of the first sequence; or
manner 2:

the first parameter is further related to a CRC length, and T is determined by using the following formula:

$$T = 2M + K + L - K1,$$

where
T represents the first parameter, M represents the quantity of modulation symbols, K represents the length of the information bit sequence, K 1 represents the length of the first sequence, and L represents the CRC length.

In addition, it should be further noted that the first sequence may be a plurality of bits, and there may also be a plurality of first-type sub-blocks. Assuming that the first sequence is q sub-sequences, when the first parameter is related to the CRC length, the first parameter may be determined by referring to the following formula:

$$T = 2qM + K + L - \sum_{x=1}^{q} K_{x,1},$$

where
T represents the first parameter, M represents the quantity of modulation symbols, K represents the length of the information bit sequence, q represents a quantity of sub-sequences of the first sequence, K1 represents the length of the first sequence, L represents the CRC length, and $K_{x,1}$ represents a length of an $x^{th}$ sub-sequence.
In an optional implementation, the sending apparatus or the receiving apparatus may select T sequence elements from the predefined sequence as the first index set according to a first rule, where the first rule includes one of the following: selecting T sequence elements forward from the last sequence element of the predefined sequence as the first index set, and selecting T sequence elements backward from the 1st sequence element of the predefined sequence as the first index set.
According to a second aspect, this application provides a communication apparatus. The communication apparatus may be understood as the foregoing sending apparatus, and includes an input/output unit and a processing unit.
The input/output unit is configured to obtain an information bit sequence, where a length of the information bit sequence is K, and K is a positive integer. The processing unit is configured to: determine a length K1 of a first sequence based on K or M, where M is a quantity of modulation symbols, and K1 and M are positive integers; obtain a first vector based on K, K1, and a predefined sequence, where a length of the first vector is 2JM, M is the quantity of modulation symbols, J is a modulation order, M and J are positive integers, the first vector indicates J coding sub-blocks, the J coding sub-blocks separately belong to a first-type sub-block or a second-type sub-block, the first-type sub-block includes at least one coding sub-block, and the second-type sub-block includes at least one coding sub-block; determine frozen bit locations in the first-type sub-block and information bit locations in the second-type sub-block; and encode the information bit sequence based on the frozen bit locations in the first-type sub-block, the information bit locations in the second-type sub-block, and the first vector.
In an optional implementation, the processing unit is specifically configured to:
determine a first index set $\Theta$ based on K, K1, and the predefined sequence; and obtain the first vector based on the first index set $\Theta$, where a location index i in the first vector satisfies: if $i \in \Theta$, the location i carries a first preset value; and if $i \notin \Theta$, the location i carries a second preset value, where the first preset value is different from the second preset value, $1 \leq i \leq 2JM$, and i is a positive integer.
In an optional implementation, an element carried at a $(2M(y - 1) + 1)^{th}$ location in the first vector to an element carried at a $(2My)^{th}$ location in the first vector correspond to a $y^{th}$ coding sub-block, $1 \leq y \leq J$, and y is a positive integer.
In an optional implementation, the processing unit is further configured to: select F information bit locations from the information bit locations in the second-type sub-block, where F is a length of frozen bits in the first-type sub-block, and F is an integer; and assign values of the F frozen bit locations in the first-type sub-block to the F information bit locations in the second-type sub-block.

In an optional implementation, the processing unit is further configured to: perform shaping mapping and polar transform on the first sequence to obtain a third sequence; extract a fourth sequence from the third sequence based on the first vector, where an element in the fourth sequence is a value of an information bit location in the first-type sub-block, and a length of the fourth sequence is less than a length of the third sequence; perform cyclic redundancy check CRC calculation on a fifth sequence to obtain a sixth sequence, where the fifth sequence includes a second sequence and the fourth sequence; and encode the sixth sequence.

In an optional implementation, K1 is determined in the following manner:

manner 1: determining K1 based on an index value corresponding to K or M; or
manner 2:

determining K1 by using the following formula:

$$K1 = \left\lfloor \log_2 C_{2M}^{\lfloor 2Mp_{bias} \rfloor} \right\rfloor,$$

where

K1 represents a length of a first sequence, M represents the quantity of modulation symbols, and $p_{bias}$ represents a preset shaping probability.

In an optional implementation, the processing unit is specifically configured to: determine a first parameter T based on K and K1, and select T sequence elements from the predefined sequence to construct the first index set $\Theta$.

In an optional implementation, T is determined in the following manner:

manner 1:

$$T = 2M + K - K1,$$

where

T represents the first parameter, M represents the quantity of modulation symbols, K represents the length of the information bit sequence, and K1 represents the length of the first sequence; or
manner 2:

the first parameter is further related to a CRC length, and T is determined by using the following formula:

$$T = 2M + K + L - K1,$$

where

T represents the first parameter, M represents the quantity of modulation symbols, K represents the length of the information bit sequence, K 1 represents the length of the first sequence, and L represents the CRC length.

In an optional implementation, the processing unit is specifically configured to:
select T sequence elements from the predefined sequence as the first index set according to a first rule, where the first rule includes one of the following: selecting T sequence elements forward from the last sequence element of the predefined sequence as the first index set, and selecting T sequence elements backward from the 1$^{st}$ sequence element of the predefined sequence as the first index set.

In an optional implementation, the first preset value is 1, and the second preset value is 0; or the first preset value is 0, and the second preset value is 1.

According to a third aspect, this application provides a communication apparatus. The communication apparatus may be understood as a receiving apparatus, and may include an input/output unit and a processing unit.

The input/output unit is configured to: obtain a to-be-decoded sequence; and determine K and M, where K is a length of an information bit sequence, and M is a quantity of modulation symbols. The processing unit is configured to: determine K1 based on K or M, where K, K1, and M are positive integers; obtain a first vector based on K, K1, and a predefined sequence, where a length of the first vector is 2JM, J is a modulation order, J is a positive integer, the first vector indicates J coding sub-blocks, the J coding sub-blocks separately belong to a first-type sub-block or a second-type sub-block, the first-type sub-block includes at least one coding sub-block, and the second-type sub-block includes at least one coding sub-block; determine frozen bit locations in the first-type sub-block and information bit locations in the second-type sub-block; and decode the to-be-decoded sequence based on the frozen bit locations in the first-type sub-block, the information bit locations in the second-type sub-block, and the first vector, to obtain the information bit sequence whose length is K.

In an optional implementation, the processing unit is specifically configured to: determine a first index set $\Theta$ based on K, K1, and the predefined sequence, and obtain the first vector based on the first index set $\Theta$, where a location index i in the first vector satisfies:

if $i \in \Theta$, the location i carries a first preset value; and

if $i \notin \Theta$, the location i carries a second preset value, where the first preset value is different from the second preset value, $1 \le i \le 2JM$, and i is a positive integer.

In an optional implementation, an element carried at a $(2M(y-1)+1)^{th}$ location in the first vector to an element carried at a $(2My)^{th}$ location in the first vector correspond to a $y^{th}$ coding sub-block, $1 \le y \le J$, and y is a positive integer.

In an optional implementation, the processing unit is further configured to: select F information bit locations from the information bit locations in the second-type sub-block, where F is a length of frozen bits in the first-type sub-block, and F is an integer; and assign values of the F frozen bit locations in the first-type sub-block to the F information bit locations in the second-type sub-block.

In an optional implementation, K1 is determined in the following manner:

manner 1:
determining K1 based on an index value corresponding to K or M; or
manner 2:
determining K1 by using the following formula:

$$K1 = \left\lfloor \log_2 C_{2M}^{\left\lfloor 2Mp_{bias} \right\rfloor} \right\rfloor,$$

where
K1 represents a length of the first sequence; M represents a quantity of modulation symbols; and $p_{bias}$ represents a preset shaping probability.

In an optional implementation, the processing unit is specifically configured to: determine a first parameter T based on K and K1, and select T sequence elements from the predefined sequence to construct the first index set $\Theta$.

In an optional implementation, T is determined in the following manner:

manner 1:

$$T = 2M + K - K1,$$

where
T represents the first parameter, M represents the quantity of modulation symbols, K represents the length of the information bit sequence, and K1 represents the length of the first sequence; or
manner 2:

the first parameter is further related to a CRC length, and T is determined by using the following formula:

$$T = 2M + K + L - K1,$$

where
T represents the first parameter, M represents the quantity of modulation symbols, K represents the length of the information bit sequence, K 1 represents the length of the first sequence, and L represents the CRC length.

In an optional implementation, the processing unit is specifically configured to select T sequence elements from the predefined sequence as the first index set according to a first rule, where the first rule includes one of the following: selecting T sequence elements forward from the last sequence element of the predefined sequence as the first index set, and selecting T sequence elements backward from the 1st sequence element of the predefined sequence as the first index set.

In an optional implementation, the first preset value is 1, and the second preset value is 0; or the first preset value is 0, and the second preset value is 1.

For the second aspect or the third aspect, it should be understood that the input/output unit may be referred to as a transceiver unit, a communication unit, or the like. When the communication apparatus is a terminal device, the input/output unit may be a transceiver, and the processing unit may be a processor. When the communication apparatus is a module (for example, a chip) in a terminal device, the input/output unit may be an input/output interface, an input/output circuit, an input/output pin, or the like, and may also be referred to as an interface, a communication interface, an interface circuit, or the like. The processing unit may be a processor, a processing circuit, a logic circuit, or the like.

According to a fourth aspect, this application provides a communication apparatus, including at least one processor and a memory. The memory is configured to store a computer program or instructions. When the apparatus runs, the at least one processor executes the computer program or the instructions, so that the communication apparatus performs the method according to the first aspect or the implementations of the first aspect.

According to a fifth aspect, this application provides another communication apparatus, including an interface circuit and a logic circuit. The interface circuit may be understood as an input/output interface, and the logic circuit may be configured to run code instructions to perform the method according to the first aspect or the implementations of the first aspect.

According to a sixth aspect, this application further provides a computer-readable storage medium, where the computer-readable storage medium stores computer-readable instructions. When the computer-readable instructions are run on a computer, the computer is enabled to perform the method according to any one of the first aspect or the possible designs of the first aspect.

According to a seventh aspect, this application further provides a computer program product including instructions. When the instructions are run on a computer, the computer performs the method according to the first aspect or the implementations of the first aspect.

According to an eighth aspect, this application provides a chip system. The chip system includes a processor, and may further include a memory, configured to implement the method according to any one of the first aspect or the possible designs of the first aspect. The chip system may include a chip, or may include a chip and another discrete component.

According to a ninth aspect, this application provides a communication system, where the system includes a sending apparatus and a receiving apparatus. The communication system is configured to perform the method according to any one of the first aspect or the possible designs of the first aspect.

For technical effects that can be achieved in the second aspect to the ninth aspect, refer to descriptions of technical effects that can be achieved by corresponding possible design solutions in the first aspect. Details are not described herein again in this application.

## BRIEF DESCRIPTION OF DRAWINGS

FIG. 1 is a schematic diagram of a communication system according to an embodiment of this application;
FIG. 2 is a schematic diagram of an encoding and decoding procedure according to an embodiment of this application;
FIG. 3 is a schematic diagram of polar coding according to an embodiment of this application;
FIG. 4 is a schematic flowchart of an encoding and decoding method according to an embodiment of this application;
FIG. 5 is a schematic diagram of a CRC execution procedure according to an embodiment of this application;
FIG. 6 is a schematic diagram of encoding according to an embodiment of this application;
FIG. 7 is a schematic flowchart of performing polar shaping according to an embodiment of this application;
FIG. 8 is a schematic diagram of modulation symbol mapping according to an embodiment of this application;
FIG. 9 is a comparison diagram showing simulation results;
FIG. 10 is a comparison diagram showing simulation results;
FIG. 11 is a schematic diagram of a structure of a communication apparatus according to an embodiment of this application;
FIG. 12 is a schematic diagram of a structure of a communication apparatus according to an embodiment of this application; and

FIG. 13 is a schematic diagram of a structure of a communication apparatus according to an embodiment of this application.

**DESCRIPTION OF EMBODIMENTS**

To make the objectives, technical solutions, and advantages of this application clearer, the following further describes this application in detail with reference to the accompanying drawings. A specific operation method in a method embodiment may also be applied to an apparatus embodiment or a system embodiment. In the descriptions of this application, unless otherwise specified, a plurality of means two or more than two. Therefore, for implementation of the apparatus and the method, reference may be made to each other, and repeated parts are not described again.

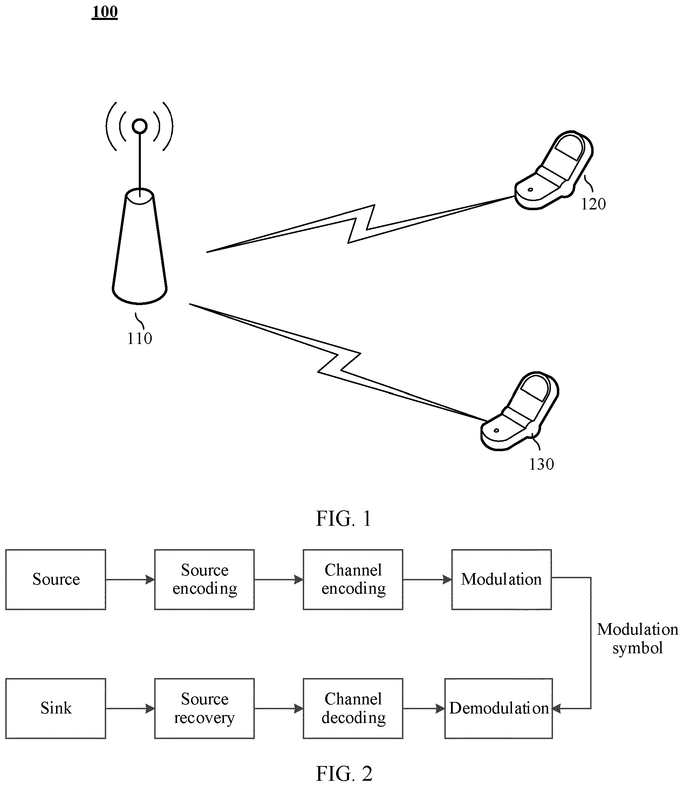

This application may be applied to a 5G NR system, or may be applied to another communication system, for example, a next-generation communication system. As shown in FIG. 1, an embodiment of this application may be applied to a communication system 100. The communication system includes a network device 110, a terminal device 120, and a terminal device 130. When the network device 110 is a transmitter, the terminal device 120 or the terminal device 130 is a receiver. When the terminal device 120 or the terminal device 130 is a transmitter, the network device 110 is a receiver. The transmitter may also be referred to as a sending apparatus, and the receiver may also be referred to as a receiving apparatus. The network device may be a base station, may be a device obtained by integrating a base station and a base station controller, or may be another device having a similar communication function.

The network device is an apparatus deployed in a radio access network to provide a wireless communication function for the terminal device. An access network device is a device having a wireless transceiver function or a chip that can be disposed in the device. The device includes but is not limited to: an evolved NodeB (evolved NodeB, eNB), a radio network controller (radio network controller, RNC), a NodeB (NodeB, NB), a base station controller (base station controller, BSC), a base transceiver station (base transceiver station, BTS), a home base station (for example, a home evolved NodeB, or a home NodeB, HNB), a baseband unit (baseband unit, BBU); an access point (access point, AP), a radio relay node, a wireless backhaul node, a transmission point (transmission and reception point, TRP, or transmission point, TP), or the like in a wireless fidelity (wireless fidelity, Wi-Fi) system; a gNB or a transmission point (TRP or TP) in a 5G (for example, NR) system, or one antenna panel or a group of (including a plurality of antenna panels) antenna panels of a base station in the 5G system; or a network node that forms a gNB or a transmission point, for example, a baseband unit (BBU), a distributed unit (distributed unit, DU), a satellite, or an unmanned aerial vehicle.

In some deployment, the gNB may include a central unit (centralized unit, CU) and a DU. The gNB may further include a radio unit (radio unit, RU). The CU implements some functions of the gNB, and the DU implements some functions of the gNB. For example, the CU implements functions of a radio resource control (radio resource control, RRC) layer and a packet data convergence protocol (packet data convergence protocol, PDCP) layer. The DU implements functions of a radio link control (radio link control, RLC) layer, a media access control (media access control, MAC) layer, and a physical (physical, PHY) layer. Information at the RRC layer eventually becomes information at the PHY layer (in other words, information sent through the PHY layer), or is converted from information at the PHY layer. Therefore, in this architecture, higher layer signaling, for example, RRC layer signaling or PDCP layer signaling, may also be considered as being sent by the DU or sent by the DU and the RU. It may be understood that the access network device may be a CU node, a DU node, or a device including the CU node and the DU node. In addition, the CU may be classified as a network device in a radio access network (radio access network, RAN), or the CU may be classified as a network device in a core network CN. This is not limited herein.

The terminal device in embodiments of this application, which may also be referred to as a terminal, is an entity configured to receive or transmit a signal on a user side, and is configured to send an uplink signal to a network device or receive a downlink signal from a network device. The terminal device includes a device that provides a user with voice and/or data connectivity, for example, may include a handheld device having a wireless connection function or a processing device connected to a wireless modem. The terminal device may communicate with a core network over a RAN, and exchange a voice and/or data with the RAN. The terminal device may include UE, a vehicle to everything (vehicle to x, V2X) terminal device, a wireless terminal device, a mobile terminal device, a device-to-device (device-to-device, D2D) terminal device, a machine to machine/machine type communications (machine-to-machine /machine-type communications, M2M/MTC) terminal device, an internet of things (internet of things, IoT) terminal device, a subscriber unit (subscriber unit), a subscriber station (subscriber station), a mobile station (mobile station), a remote station (remote station), an access point (access point, AP), a remote terminal (remote terminal), an access terminal (access terminal), a user terminal (user terminal), a user agent (user agent), a user device (user device), a wearable device, a vehicle-mounted device, an unmanned aerial vehicle, or the like.

As an example instead of a limitation, in embodiments of this application, the terminal device may alternatively be a wearable device. The wearable device may also be referred to as a wearable intelligent device, an intelligent wearable device, or the like, and is a general term of wearable devices that are intelligently designed and developed for daily wear by using a wearable technology, for example, glasses, gloves, watches, clothes, and shoes. The wearable device is a portable device that can be directly worn on the body or integrated into clothes or an accessory of a user. The wearable device is not only a hardware device, but also implements a powerful function through software support, data exchange, and cloud interaction. In a broad sense, wearable intelligent devices include full-featured and large-sized devices that can implement all or a part of functions without depending on smartphones, for example, smart watches or smart glasses, and include devices that dedicated to only one type of application function and need to collaboratively work with other devices such as smartphones, for example, various smart bands, smart helmets, or smart jewelry for monitoring physical signs.

If the various terminal devices described above are located in a vehicle (for example, placed in the vehicle or installed in the vehicle), the terminal devices may be all considered as vehicle-mounted terminal devices. For example, the vehicle-mounted terminal devices are also referred to as on-board units (on-board unit, OBU).

In descriptions of embodiments of this application, the term "and/or" describes an association relationship between associated objects and indicates that three relationships may exist. For example, A and/or B may indicate the following three cases: Only A exists, both A and B exist, and only B exists. The character "/" generally indicates an "or" relationship between the associated objects. In this application, "at least one" means one or more, and "a plurality of" means two or more. In addition, it should be understood that in description of this application, terms such as "first" and "second" are merely used for distinguishing and description, but should not be understood as indicating or implying relative importance, or should not be understood as indicating or implying a sequence.

In the communication system in FIG. 1, to ensure security of communication between communication devices, coding processing may be performed on information. Refer to an encoding and decoding procedure shown in FIG. 2. A source of a transmitter sequentially performs source encoding, channel encoding, and modulation, and then outputs a modulation symbol. After receiving the modulation symbol, a receiver sequentially performs demodulation, channel decoding, and source recovery to obtain a sink. The receiver may obtain useful information based on the sink.

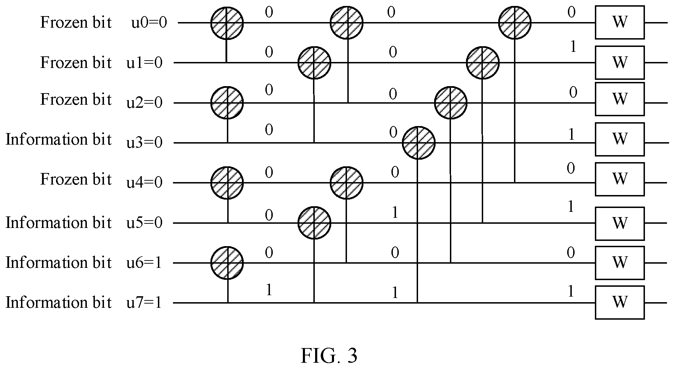

Polar is a channel coding scheme that can be strictly proved to "reach" a Shannon channel capacity, has features such as good performance and low complexity, and currently has been determined by the 3rd generation partnership project (3rd generation partnership project, 3GPP) as a 5G enhanced mobile broadband (enhance mobile broadband, eMBB) (uplink/downlink) control channel coding scheme. FIG. 3 shows a polar coding process. When performing polar, a transmitter needs to determine an information bit and a frozen bit, where $u_7$, $u_6$, $u_5$, and $u_3$ are information bits (data), and $u_4$, $u_2$, $u_1$, and $u_0$ are frozen bits (frozen). An exclusive OR (XOR) opration is performed on the information bits and the frozen bits to obtain an encoded sequence, and the encoded sequence may be transmitted to a receiver through a channel W. In actual application, the transmitter and the receiver may agree that a value of frozen is 0. Values of bits $u_0$ and $u_1$ shown in FIG. 3 are still 0 after an XOR operation is performed, an encoded sequence 01010101 is obtained after an operation is performed on the information bits and the frozen bits, and the encoded sequence is mapped to modulation symbols, and then may be transmitted on W.

To make transmitted modulation symbols conform to Gaussian distribution, a probabilistic shaping technology is introduced. Currently, in an online construction algorithm that can be based on density evolution, a soft information distribution function obtained in a decoding process of each polarized subchannel on a left side of a fence diagram is calculated by using a given signal-to-noise ratio (signal-to-noise ratio, SNR), and a channel capacity of each subchannel is obtained based on the soft information distribution function. For a sub-block of non-shaping bits, a location with higher reliability is selected as an information bit location; for a sub-block of shaping bits, a location with lower reliability is selected as a dynamic (dynamic) bit location. In this method, reliability of each sub-channel needs to be calculated on line. Implementation complexity is high. In addition, there is a polar-based offline construction method, to be specific, based on a given sequence, information bits and frozen bits are sequentially read from the sequence. However, this solution cannot adapt to a requirement of polar code construction in which probabilistic shaping is introduced.

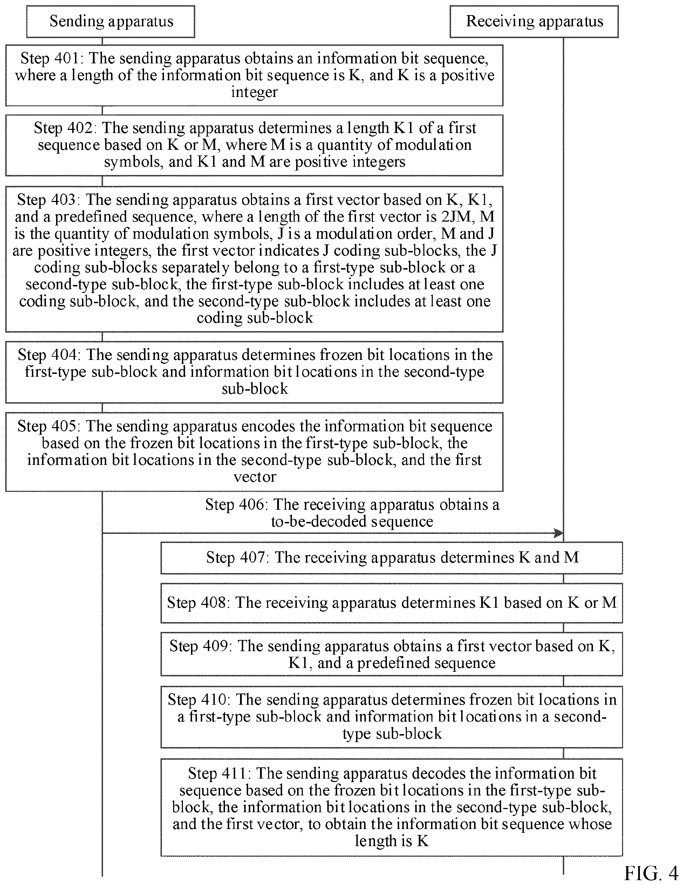

Based on this, this application provides an encoding and decoding method, to perform encoding more efficiently in an offline case. FIG. 4 shows an encoding and decoding method provided in an embodiment of this application. The encoding method may be performed by a sending apparatus, and the decoding method may be performed by a receiving apparatus. The sending apparatus may be UE, a vehicle-mounted device, a terminal device, a module (for example, a chip) in the terminal device, or the like. The sending apparatus may alternatively be a TRP, a gNB, a network device, a module (for example, a chip) in the network device, or the like. The receiving apparatus may be the same as the foregoing sending apparatus. Details are not described herein. However, the sending apparatus and the receiving apparatus are different communication apparatuses. For example, the sending apparatus is a terminal device, and the receiving apparatus may be a network device. This is not specifically limited herein in this application, and the following steps may be performed:

Step 401: The sending apparatus obtains an information bit sequence, where a length of the information bit sequence is K, and K is a positive integer.

Step 402: The sending apparatus determines a length K1 of a first sequence based on K or M, where M is a quantity of modulation symbols, and K1 and M are positive integers.

It should be noted that the encoding and decoding method provided in this application may be applied to higher-order modulation, for example, 64 QAM, 256 QAM, or 1024 QAM. The information bit sequence may be understood as a sequence that requires coding processing. The length (that is, a quantity) of the information bit sequence is determined, and the length of the information bit sequence is K. To improve robustness and reduce complexity during encoding, the information bit sequence may be divided into the first sequence and a second sequence, and different coding processing is performed for different sequences. In actual application, if shaping is introduced during encoding, the first sequence may be understood as a sequence for shaping. Certainly, in actual application, another encoding operation (an operation different from conventional polar coding) may be introduced, and the first sequence may be a sequence for another encoding operation. This is not specifically limited in this application. The following uses an example in which the first sequence is a sequence for shaping and the second sequence is a sequence on which shaping is not performed for description. However, in actual application, another encoding operation is not limited to shaping. A sum of the length of the first sequence and a length of the second sequence is the length of the information bit sequence. To be specific, when the length K of the information bit sequence is known and the length K1 of the first sequence is known, the length of the second sequence is K-K1.

Step 403: The sending apparatus obtains a first vector based on K, K1, and a predefined sequence, where a length of the first vector is 2JM, M is the quantity of modulation symbols, J is a modulation order, M and J are positive integers, the first vector indicates J coding sub-blocks, the J coding sub-blocks separately belong to a first-type sub-block or a second-type sub-block, the first-type sub-block includes at least one coding sub-block, and the second-type sub-block includes at least one coding sub-block.

Step 404: The sending apparatus determines frozen bit locations in the first-type sub-block and information bit locations in the second-type sub-block.

Step 405: The sending apparatus encodes the information bit sequence based on the frozen bit locations in the first-type sub-block, the information bit locations in the second-type sub-block, and the first vector.

It should be noted that, after performing step 404, the sending apparatus may obtain an encoded sequence, and transmit the encoded sequence to the receiving apparatus. However, when the encoded sequence is transmitted on a channel between the sending apparatus and the receiving apparatus, interference or the like may exist. Therefore, after the encoded sequence is transmitted on the channel, the encoded sequence is a to-be-decoded sequence. The to-be-decoded sequence may be understood as a scrambled encoded sequence.

Step 406: The receiving apparatus obtains the to-be-decoded sequence.

Step 407: The receiving apparatus determines K and M. Values of K and M may be obtained by using indication signaling. The indication signaling may be UCI, DCI, or the like, or may be agreed upon with the sending apparatus in advance. This is not specifically limited herein.

Step 408: The receiving apparatus determines K1 based on K or M.

Step 409: The receiving apparatus obtains a first vector based on K, K1, and a predefined sequence, where a length of the first vector is 2JM, M is a quantity of modulation symbols, J is a modulation order, M and J are positive integers, the first vector indicates J coding sub-blocks, the J coding sub-blocks separately belong to a first-type sub-block or a second-type sub-block, the first-type sub-block includes at least one coding sub-block, and the second-type sub-block includes at least one coding sub-block.

Step 410: The receiving apparatus determines frozen bit locations in the first-type sub-block and information bit locations in the second-type sub-block.

Step 411: The receiving apparatus decodes the to-be-decoded sequence based on the frozen bit locations in the first-type sub-block, the information bit locations in the second-type sub-block, and the first vector, to obtain the information bit sequence whose length is K.

It should be noted that, when an encoding operation or a decoding operation is performed, a modulation scheme (for example, the modulation scheme is 64QAM higher-order modulation), the modulation order J being 3 ( $J=\log_2(\sqrt{64})=3$ ), and the quantity M of modulation symbols (the quantity of modulation symbols may be preset, for example, agreed upon by the sending apparatus and the receiving apparatus) need to be determined, to construct the first vector whose length is 2JM based on K, K1, the predefined sequence, the modulation order, and the quantity of modulation symbols. A location of the information bit sequence corresponding to the first vector may be determined based on the first vector (for example, if the information bit sequence is [0 10], and the first vector is [0 0 0 0 0 1 1 1], the information bit sequence may correspond to 111 in the first vector. In this case, when an encoding operation is performed, the 6th, the 7th, and the 8th locations may be set as information bit locations, and other locations may be set as frozen bit locations). In addition, the information bit locations and the frozen bit locations may be determined by using the first vector, and an encoding operation may be efficiently performed based on the obtained frozen bit locations and the obtained information bit locations.

In addition, the first vector may indicate the J coding sub-blocks, the J coding sub-blocks separately belong to the first-type sub-block or the second-type sub-block, the first-type sub-block includes one coding sub-block, and the second-type sub-block may include at least one coding sub-block. Because another encoding operation such as a shaping operation may be introduced during encoding, the first-type sub-block may be understood as a shaping sub-block. To ensure that a decoder, that is, the receiving apparatus, can more quickly obtain the information bit sequence through decoding when another encoding operation is introduced, the information bit sequence may be encoded based on the frozen bit locations in the first-type sub-block, the information bit locations in the second-type frozen bit, and the first vector, to improve decoding efficiency of the decoder.

When an encoding operation is performed in this application, a solution (that is, online coding) of adjusting a coding policy based on a channel status is not used. Instead, the first vector is constructed based on the length of the information bit sequence, the length of the first sequence, and the predefined sequence, different coding sub-blocks are indicated based on the first vector, and the information bit sequence is encoded based on information bit locations and frozen bit locations in the different coding sub-blocks and the first vector. In this way, encoding and decoding efficiency can be improved, and calculation complexity is reduced compared with online coding.

In an optional implementation, the sending apparatus or the receiving apparatus may determine K1 in the following manner:

Manner 1: K1 is determined based on an index value corresponding to K or M.

For example, an index table of a correspondence between K and K1 is stored in the sending apparatus or the receiving apparatus, and K1 is directly read based on an index value in the index table. As shown in Table 1, an index number of an information bit sequence whose length is 111 is 001, and a length of a corresponding first sequence is 37. The sending apparatus or the receiving apparatus may determine the length of the first sequence by obtaining the index number. In actual application, only one or more rows in the table may be used. This is not specifically limited in this application. In addition, in Table 1, in actual storage, only the first column and the third column, or the second column and the third column may be stored, and the length of the first sequence in the third column is directly determined based on a value of the first column or a value of the second column. This is not specifically limited herein in this application.

**Table 1**

| Index number (index) | Length (K) of an information bit sequence | Length (K1) of a first sequence |
|---|---|---|
| 001 | 111 | 37 |
| 010 | 150 | 50 |
| 011 | 210 | 70 |
| ... | ... | ... |

For example, an index table of a correspondence between M and K1 is stored in the sending apparatus or the receiving apparatus, and K1 is directly read based on an index value in the index table. As shown in Table 2, an index number of an information bit sequence whose M is 32 is 001, and a length of a corresponding first sequence is 23. The sending apparatus or the receiving apparatus may determine the length of the first sequence by obtaining the index number. In actual application, only one or more rows in the table may be used. This is not specifically limited in this application. In addition, in Table 2, in actual storage, only the first column and the third column, or the second column and the third column may be stored, and the length of the first sequence in the third column is directly determined based on a value of the first column or a value of the second column. This is not specifically limited herein in this application.

**Table 2**

| Index number (index) | Quantity (M) of modulation symbols | Length (K1) of a first sequence |
|---|---|---|
| 001 | 32 | 23 |
| 010 | 64 | 60 |
| 011 | 128 | 70 |
| ... | ... | ... |

Manner 2:

The sending apparatus or the receiving apparatus may determine K1 by using the following formula 1:

$$K1 = \left\lfloor \log_2 C_{2M}^{\lfloor 2Mp_{bias} \rfloor} \right\rfloor \qquad\qquad \text{Formula 1}$$

K1 represents a length of the first sequence; M represents a quantity of modulation symbols; and $p_{bias}$ represents a preset shaping probability.

It should be noted that the preset shaping probability may be 0.3, 0.4, or the like, and may be determined based on an actual requirement. This is not specifically limited in this application. Alternatively, the preset shaping probability is directly obtained from signaling information, for example, UCI or DCI. This is not specifically limited in this application. For example, M is 5, and $p_{bias}$ is 0.4. K1 may be calculated according to the formula 1, where

$$K1 = \left\lfloor \log_2 C_{2 \cdot 5}^{\lfloor 2 \cdot 5 \cdot 0.4 \rfloor} \right\rfloor = \left\lfloor \log_2 C_{10}^4 \right\rfloor = \left\lfloor \log_2 210 \right\rfloor = 7$$

. Therefore, it can be learned that the length of the first sequence is 7.

It should be noted that, determining K1 in the manner 1 is simpler, and has a smaller calculation amount. In the manner 2, K1 is determined based on the quantity of modulation symbols and the preset shaping probability. Compared with the manner 1, in the manner 2, a calculation amount is increased, but reliability is higher and flexibility is higher. In addition, K1 calculation is not strictly limited to the foregoing calculation. A value may be added to or subtracted from K1 after K1 is determined in the manner 1 or the manner 2. Impact on performance is also small.

In an optional implementation, the sending apparatus or the receiving apparatus may determine a first index set $\Theta$ based on K, K1, and the predefined sequence, and obtain the first vector based on the first index set $\Theta$, where a location index i in the first vector satisfies:

if $i \in \Theta$, the location i carries a first preset value; and
if $i \notin \Theta$, the location i carries a second preset value, where the first preset value is different from the second preset value, $1 \le i \le 2JM$, and i is a positive integer.

The predefined sequence may be understood as a sequence that meets a mother code length (a sequence length meets $2^N$, where N is a positive integer), for example, a sequence whose length is 8: [1, 2, 3, 5, 4, 6, 7, 8]; or may be understood as another sequence, for example, a sequence pre-agreed upon by the sending apparatus and the receiving apparatus. This is not specifically limited in this application.

It should be noted that, the first index set includes an element selected from the predefined sequence. For example, if the predefined sequence is [1 2 3 5 4 6 7 8], and sequence elements selected from the predefined sequence are 4, 6, 7, and 8, the first index set is {4, 6, 7, 8}. Alternatively, the first index set is an index set obtained by transforming the predefined sequence. For example, if the predefined sequence is [1 2 3 5 4 6 7 8], and it is determined, based on K and K1, that a change manner of the predefined sequence is subtracting 1 from all elements of the sequence to obtain the first index set, the first index set is {0, 1, 2, 4, 3, 5, 6, 7}. A manner of and a rule for determining the first index set are not specifically limited herein in this application.

If J is 2, and M is 2, the length of the first vector is 8 (2*2*2), the first index set $\Theta$ is {2, 3, 5, 6, 7}, and the location index in the first vector may carry the first preset value or the second preset value. The first preset value may be 1, and the second preset value is 0; or the first preset value may be 0, and the second preset value is 1. This is not specifically limited herein in this application. Usually, the first preset value indicates a location of the information bit sequence. If the first preset value is 1, and the second preset value is 0, the first vector is 00110111. The information bit locations and the frozen bit locations are determined by using the first vector, so that an encoding operation is efficiently performed.

In an optional implementation, after the first index set is determined, the first vector may be determined based on the first index set, where an element carried at a $(2M(y-1)+1)^{th}$ location in the first vector to an element carried at a $(2My)^{th}$ location in the first vector correspond to a $y^{th}$ coding sub-block, $1 \le y \le J$, and y is a positive integer, that is, a length of each coding sub-block indicated by the first vector is 2M. For example, if the first vector is 10001111, J is 2, and M is 2, the length of the coding sub-block is 4, and the first vector may indicate two coding sub-blocks, where the first coding sub-block corresponds to 1000, and the second coding sub-block corresponds to 1111.

After the first index set is determined based on K, K1, and the predefined sequence, the manner of obtaining the first vector based on the first index set can improve coding efficiency and reduce coding processing complexity.

In an optional implementation, the sending apparatus or the receiving apparatus may determine a first parameter T based on K and K1, and select T sequence elements from the predefined sequence to construct the first index set $\Theta$. In this way, the first index set can be quickly determined, so that the first vector can be more quickly determined based on the first index set.

In an optional implementation, the sending apparatus or the receiving apparatus may determine T by using the following formula 2:
Manner 1:

$$T = 2M + K - K1 \qquad \text{Formula 2}$$

T represents the first parameter, M represents the quantity of modulation symbols, K represents the length of the information bit sequence, and K1 represents the length of the first sequence. For example, M is 5, K is 8, and K1 is 4. T may be calculated according to the formula 2, where T=2*5+8-4=14.

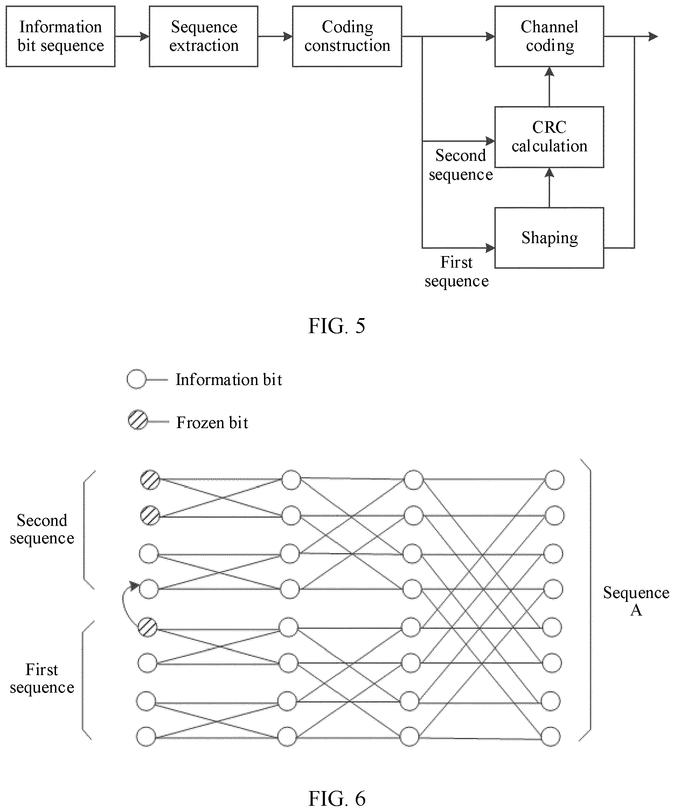

When the sending apparatus performs encoding, considering decoding performance of the receiving apparatus, in addition to encoding the information bit sequence based on the frozen bit locations in the first-type sub-block, the information bit locations in the second-type sub-block, and the first vector, the sending apparatus may further perform shaping mapping and polar transform on the first sequence to obtain a third sequence; extract a fourth sequence from the third sequence based on the first vector, where an element in the fourth sequence is a value of an information bit location in the first-type sub-block, and a length of the fourth sequence is less than a length of the third sequence; perform CRC calculation on a fifth sequence to obtain a sixth sequence, where the fifth sequence includes a second sequence and the fourth sequence; and encode the sixth sequence. As shown in FIG. 5, after obtaining the information bit sequence, the sending apparatus performs an extraction operation on the information bit sequence to obtain the first sequence and the second sequence, and then performs coding construction based on the first sequence and the second sequence. After the first sequence is shaped and CRC calculation is performed on both the first sequence and the second sequence, the first sequence and the second sequence are output after channel coding is performed.

When performing, the CRC operation may be performed in the following manner:

(1) Based on the length K1 of the first sequence and the length K-K1 of the second sequence, input information bits $b_1$, $b_2$, ..., and $b_K$ are grouped in the following manner:

$u_i = b_i$, and the bits are grouped into I row; and formula pair output;
$v_i = b_{i+K-K1}$, where K-K1K1.

(2) $v_i$ is shaped to obtain a bit sequence with a length of 2M, and the bit sequence is denoted as $s_1$, $s_2$, ..., $s_2M$.
(3) Polar transform is performed on $s_1$, $s_2$, ..., and $s_{2M}$ to obtain the third sequence, and values corresponding to information bit locations are extracted from the third sequence based on 2M locations in the first-type sub-block that are indicated by the first vector, and are denoted as the fourth sequence. The fourth sequence is $h_1$, $h_2$, ..., $h_{SI}$.
(4) The fourth sequence and the second sequence are used as input sequences of a CRC encoder to perform a CRC operation. For specific CRC calculation, refer to (T. V Ramabadran and S. S. Gaitonde, "A tutorial on CRC computations," in IEEE Micro, vol. 8, no. 4, pp. 62-75, Aug. 1988, doi: 10.1109/40.7773). Details are not described herein.

In addition, in this application, an input bit sequence of the CRC encoder may be further determined in the following manner:

The second sequence and the fourth sequence are combined into a long sequence, that is, the fifth sequence, used as a sequence input to the CRC encoder. Alternatively, CRC calculation may be performed only on a subset of the second sequence or the fourth sequence. This is not specifically limited in this application.

Correspondingly, during decoding, the receiving apparatus may determine, through CRC check, whether a decoding error occurs.

It should be noted that, decoding performance can be improved by introducing CRC.

Considering that there may be CRC during encoding, the first parameter T may be further related to a CRC length, and T may be determined by using the following formula 3:

$$T = 2M + K + L - K1 \qquad \text{Formula 3}$$

T represents the first parameter, M represents the quantity of modulation symbols, K represents the length of the information bit sequence, K1 represents the length of the first sequence, and L represents the CRC length.

In addition, it should be further noted that the first sequence may be a plurality of bits, and there may also be a plurality of first-type sub-blocks. Assuming that the first sequence is q sub-sequences, when the first parameter is related to the CRC length, the first parameter may be determined by referring to the following formula 4:

$$T = 2qM + K + L - \sum_{x=1}^{q} K_{x,1} \qquad \text{Formula 4}$$

T represents the first parameter, M represents the quantity of modulation symbols, K represents the length of the information bit sequence, q represents a quantity of sub-sequences of the first sequence, K1 represents the length of the first sequence, L represents the CRC length, and $K_{x,1}$ represents a length of an $x^{th}$ sub-sequence.

When the first sequence includes a plurality of sub-sequences, K1 is determined by performing summation calculation on lengths of the plurality of sub-sequences. However, in actual application, alternatively, K1 may be determined by performing joint calculation on the sub-sequences. For example, a plurality of sub-sequences of the first sequence are combined as one high-dimensional symbol, the first sequence is 3 bits, quantities of high-dimensional

$$K1 = \log_2 \left( C_{n0+n1+n2}^{n0} * C_{n1+n2}^{n1} \right)$$

symbols are respectively n0, n1, and n2. In this case, . In actual application, the value of K1 may alternatively be determined in another manner when the first sequence is a plurality of sub-sequences. This is not specifically limited in this application.

It should be further noted that, regardless of whether T is related to the CRC length or whether the first sequence is a plurality of bits, the sending apparatus or the receiving apparatus may select T sequence elements from the predefined sequence as the first index set according to a first rule, where the first rule includes one of the following: selecting T sequence elements forward from the last sequence element of the predefined sequence as the first index set, and selecting T sequence elements backward from the 1st sequence element of the predefined sequence as the first index set. For example, the predefined sequence is [1 2 3 5 4 6 7 8], and T is 5. Five sequence elements may be selected from the last sequence element forward as the first index set. For example, the first index set is {8, 7, 6, 4, 5}. Alternatively, T sequence elements may be selected from the 1st sequence element backward as the first index set. For example, the first index set is {1, 2, 3, 5, 4}. Alternatively, T sequence elements may be selected from an element previous to the last sequence element of the predefined sequence as the first index set. For example, the first index set is {7, 6, 4, 5, 3}. In addition, in actual application, there may be another selection manner. This is not specifically limited in this application.

In an optional implementation, after determining the first vector based on the first index set, the sending apparatus or the receiving apparatus may determine the frozen bit locations in the first-type sub-block and the information bit locations in the second-type sub-block; select F information bit locations from the information bit locations in the second-type sub-block, where F is a length of frozen bits in the first-type sub-block, and F is an integer; and assign values of F frozen bits in the first-type sub-block to the F information bit locations in the second-type sub-block.

It should be noted that, assigning the values of the F frozen bits in the first-type sub-block to the F information bit locations in the second-type sub-block may be understood as directly duplicating the values of the F frozen bits in the first-type sub-block to the information bit locations in the second-type sub-block, or may be understood as assigning the values of the F frozen bits in the first-type sub-block to the information bit locations in the second-type sub-block through encoding (scrambling, exclusive OR, or the like). In actual application, a value assignment manner is not specifically limited in this application.

In addition, in actual application, the length of the frozen bits in the first-type sub-block may alternatively be F1 (if a length of all frozen bits in the first-type sub-block is 5, F1 may be 3 or another value less than 5), and F2 information bit locations may be selected from the information bit locations in the second-type sub-block. A value of F2 may be different from that of F1. This is not specifically limited herein in this application, provided that a relationship between the frozen bits of the first-type sub-block and information bits of the second-type sub-block may be determined.

It should be noted that, in actual application, there may be a plurality of second-type sub-blocks, there may be a plurality of first-type sub-block, and lengths of the first-type sub-block and the second-type sub-block are the same. After the frozen bit locations are determined in the first-type sub-block, a quantity of information bits that may exist in the second-type sub-block is far greater than a quantity of frozen bits in the first-type sub-block. When the information bits in the second-type sub-block are selected, the information bits with the largest indexes in the second-type sub-block may be selected, or information bits with the smallest row weight (that is, the first preset value is the smallest) in the second-type sub-block may be selected. Certainly, random selection may be performed. After some information bits of one of the second-type sub-blocks are selected, some information bits of another second-type sub-block are selected, to construct, with the frozen bits in the first-type sub-block, a check relationship between the frozen bits in the first-type sub-block and the information bits in the second-type sub-block according to a preset check rule. As shown in FIG. 6, it is assumed that the length of the information bit sequence is 8, where the length of the first sequence is 4, and the length of the second sequence is 4. Frozen bits are represented by using shadow-filled circles, and circles that are not filled are information bits. There is one frozen bit in the first sequence, and there are two information bits in the second sequence. In the figure, a check relationship is constructed only by using the frozen bit of the first sequence and the 2nd

information bit (counted from top to bottom) of the second sequence. However, in actual application, the check relationship may alternatively be established between the frozen bit of the first sequence and the 1st information bit of the second sequence. Coding processing is performed based on the check relationship between the frozen bits of the first sequence and the information bits of the second sequence, and locations and values of information bits and the frozen bits of the sequences, to obtain an encoded sequence, that is, a sequence A on the right side of FIG. 6. It should be noted that, in this application, the check relationship between the frozen bits of the first-type sub-block and the second-type information bits is determined, to help the receiving apparatus perform decoding more quickly.

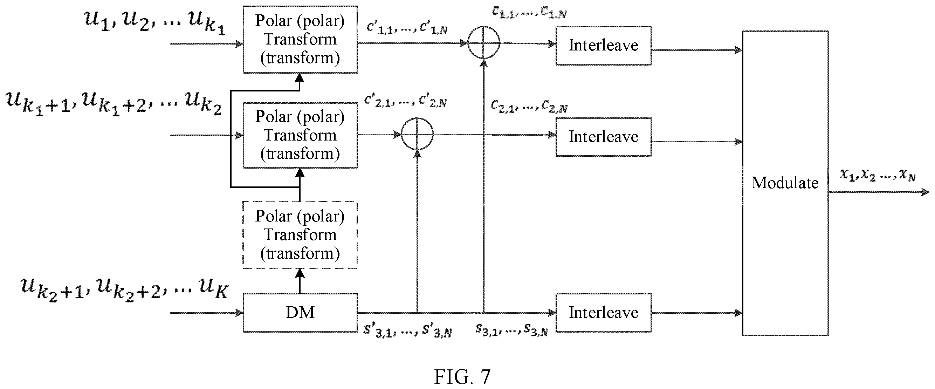

It should be further noted that, the foregoing mentions shaping, but does not specifically mention how to perform a shaping operation. An encoding operation based on polar shaping may be understood by referring to FIG. 7. FIG. 7 is merely an example for description. In actual application, polar shaping that can be applied to this application is not specifically limited.

The sending apparatus may divide the information bit sequence whose length is $K$ into three groups, which are denoted as $U_1 = u_1, u_2, ... u_{k_1}$, $U_2 = u_{k_1+1}, u_{k1+2}, ... u_{k_2}$, and $U_3 = u_{k_2+1}, u_{k_2+2}, ... u_K$. The sequence $U_3$ is mapped by using a distribution matcher, to obtain $S'_3 = s'_{3,1}, ..., s'_{3,N}$. N is a symbol sequence length. $m_{3,1}, ... , m_{3,N}$ is obtained by performing polar transform (transform) on $S'_3$. Polar channel coding is performed on a sequence $M_{3,F} = \{m_{3,i}, i \in F\}$ and $U_1, U_2$ separately, to obtain $C'_1 = c'_{1,1}, ... , c'_{1,N}$, and $C'_2 = c'_{2,1}, ... , c'_{2,N}$. $C'_1$, $C'_2$, and $S'_3$ are concatenated as a long code, to obtain $C_1$, $C_2$, and $S_3$. Polar transform is performed on $c'_{1,i}$, $c'_{2,i}$, and $s'_{3,i}$, to obtain $c_{1,i}$, $c_{2,i}$, and $s_{3,i}$. Intra-block interleaving is separately performed on $C_1$, $C_2$ and $S_3$, to obtain $C_1$, $C_2$ and $S_3$. $C_1$, $C_2$, and $S_3$ are mapped to an 8-amplitude shift keying (amplitude-shift keying, ASK) modulation symbol, which is denoted as $X$, where $c_{1,i}$, $c_{2,i}$, and $s_{3,i}$ are mapped to $x_i$. When a sequence is mapped to a modulation symbol, refer to the following rules:

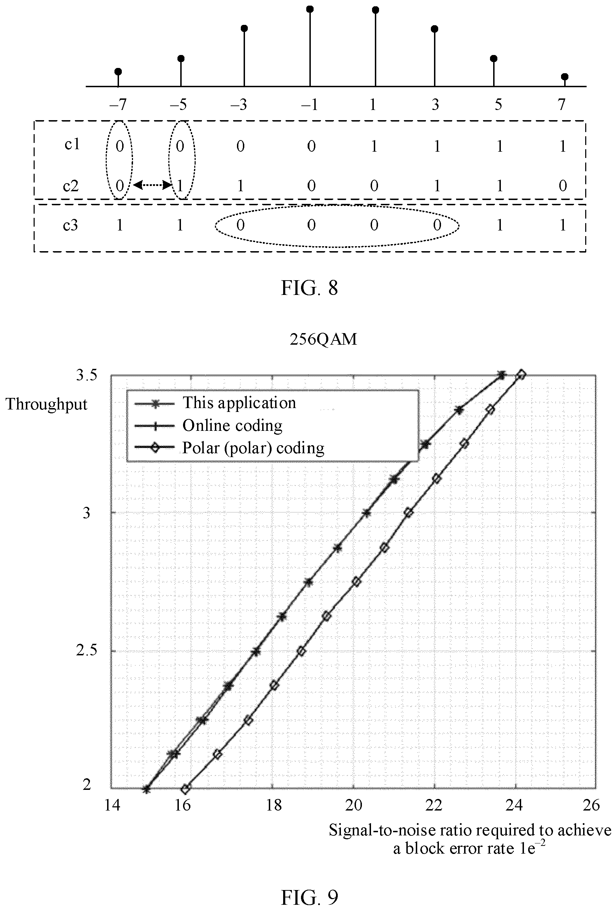

(1) The Gray mapping rule is met, that is, adjacent symbols have only one different bit.
(2) Mapping of the last sequence complies with that bits in a middle half differ from bits on both sides. For example, s3 is [1 1 0 0 0 0 1 1]. Four bits in the middle are different from four bits on both sides, as shown in FIG. 8.

In addition, FIG. 9 is a schematic diagram of simulation results of online coding and coding without shaping processing during coding according to this application. A horizontal coordinate is a signal-to-noise ratio required to reach a block error rate 1e$^{-2}$, and a vertical coordinate is a throughput. FIG. 9 shows a case in which higher-order modulation is 256QAM. A line of "case" represents a solution of this application (shaping shown in FIG. 7 is used), a line of" |" represents an online coding method, and a line of "⊔ " represents a polar coding solution (without shaping). It can be learned that offline coding construction in this application can achieve a performance gain almost consistent with online coding construction, and is obviously better than the solution without shaping.

It should be noted that, in actual application, lengths of many to-be-encoded sequences do not meet a mother code length, and the to-be-encoded sequences need to be preprocessed through rate matching. Usually, the rate matching may include puncturing, shortening, or pre-freezing. A specific rate matching manner is not limited in actual application. The following uses pre-freezing as an example. The to-be-encoded sequence is preprocessed. It may be ensured, in a pre-freezing or puncturing manner, that the to-be-encoded sequence meets a mother code length requirement. In this application, the to-be-encoded sequence is a sequence C obtained by processing the information bit sequence whose length is K, and a length of the sequence C is 2MJ, which is the same as the length of the first vector. In actual application, the following situations are considered:

Case 1: The modulation order does not meet the mother code length.

$$J \neq 2^N, \quad \left| 2^{\lceil \log_2(J) \rceil} - J \right|$$

If $\left| 2^{\lceil \log_2(J) \rceil} - J \right|$ (above) encoding sub-blocks of the sequence C whose length is 2$M$ may be pre-frozen, and information bits and frozen bits that correspond to the $\left| 2^{\lceil \log_2(J) \rceil} - J \right|$ pre-frozen encoding sub-blocks of the sequence C whose length is 2M are removed, where N is a positive integer. For example, if the modulation order is 3, which does not meet a mother code length requirement, the last coding sub-block whose length is 2M may be pre-frozen, to obtain a sequence that meets the mother code length requirement.

Case 2: The modulation symbol does not meet the mother code length.

If $M \neq 2^X$, the sequence C is divided into $J$ sub-sequences whose lengths are $2 \cdot 2^{\lceil \log_2(M) \rceil}$ , and

$$2 \square \left| 2^{\lceil \log_2(M) \rceil} - M \right|$$

information bits of each sub-sequence are pre-frozen, where X is a positive integer. For example, if the modulation symbol is 7, which does not meet a mother code length requirement, one sub-sequence may be pre-frozen.

It should be noted that performing rate matching in the foregoing manner not only can improve coding efficiency but also can read a short sequence from a long sequence. A lower-order modulation sequence is read from a higher-order modulation sequence during sequence construction, and any long sequence is extracted from a mother code length sequence. A sequence may be constructed through encoding. In this way, storage space of a device can be saved, and storage of a large quantity of sequences can be avoided.

The following shows a sequence A and a sequence B, both of which are sequences with a length of 256 and 16 ASK. A modulation order corresponding to 16 ASK is 4, and a modulation symbol is 32. A sequence whose length is less than 256 may be constructed based on the foregoing rate matching method. For example, a sequence with a length of 192 is constructed by pre-freezing a coding sub-block with a length of 64. Alternatively, another sequence whose length is less than 256 may be constructed. Details are not described herein in this application.

In the following descriptions, when encoded sub-sequences corresponding to different modulation bits undergo different (or same) interleaving, the sequence A (or the sequence B) may be used for construction.

Sequence A= [1 257 513 769 2 3 5 9 17 33 4 6 65 10 7 18 11 19 129 13 34 66 21 35 25 37 8 130 67 12 41 69 258 131 20 14 49 15 73 22 133 36 259 27 81 38 26 23 137 39 97 68 42 261 514 145 29 70 43 50 265 75 161 193 71 45 132 82 51 74 16 134 53 273 515 24 135 77 138 83 57 289 28 260 98 40 85 139 146 262 517 30 44 99 89 141 31 321 147 72 162 46 101 52 149 266 521 47 263 76 105 163 54 194 274 529 153 267 78 165 55 84 58 275 113 385 136 79 195 86 59 169 269 545 140 290 100 87 61 90 197 322 516 142 277 102 148 177 143 32 201 291 518 91 281 150 103 106 164 93 293 577 48 264 209 386 151 154 166 107 323 522 56 268 114 297 155 80 109 225 325 519 167 387 530 196 60 170 115 157 276 523 88 270 198 305 117 171 62 178 271 531 92 329 199 278 173 121 202 63 389 641 144 292 525 104 283 179 337 94 203 108 294 546 181 282 152 279 210 95 205 393 578 156 295 533 211 353 110 324 185 116 298 547 168 401 226 285 158 111 118 213 326 537 172 299 549 227 306 217 331 159 119 417 520 174 449 642 122 327 200 301 180 388 579 229 338 524 175 307 123 330 204 64 272 553 182 390 581 233 309 125 280 206 183 391 643 770 212 333 532 186 394 241 339 207 313 526 96 284 561 214 354 187 296 341 228 395 527 112 402 585 215 286 189 300 218 355 534 230 345 645 160 397 548 120 287 403 219 328 539 231 418 593 234 302 176 357 308 124 405 550 771 221 303 538 184 332 535 361 419 235 310 649 126 450 551 242 409 208 334 188 421 609 237 311 580 127 340 554 314 369 243 392 657 245 335 541 190 451 582 342 315 216 425 555 773 220 396 562 356 587 343 317 346 232 453 673 249 398 705 191 358 583 404 433 222 399 557 777 236 288 644 457 594 347 406 223 359 563 238 362 586 244 420 528 349 304 239 465 646 785 246 407 565 410 536 422 363 128 312 647 370 589 411 650 336 365 192 481 595 801 247 423 569 452 540 316 426 371 250 413 610 772 251 344 552 454 597 373 651 427 253 318 658 434 542 348 556 455 429 224 377 611 774 458 601 319 653 400 543 360 240 435 659 833 350 584 459 674 364 437 252 408 558 778 466 613 351 564 461 661 412 248 467 559 775 366 588 441 617 372 675 424 482 566 786 414 706 367 665 374 469 254 428 590 779 483 677 473 567 415 596 375 570 787 430 625 378 648 456 591 436 255 485 707 897 431 598 781 379 571 460 681 320 652 802 438 612 489 599 381 462 573 834 439 602 468 709 442 654 256 497 614 789 463 660 803 352 689 470 655 443 544 793 484 713 805 368 603 471 662 445 615 776 474 618 486 676 605 416 560 898 376 721 835 475 663 487 666 490 678 780 432 619 809 380 568 477 626 837 440 667 899 491 592 621 382 737 788 498 679 782 464 708 572 444 682 817 493 627 783 383 669 600 499 710 841 501 629 790 683 901 574 446 690 804 472 604 795 476 711 488 685 849 505 633 806 714 575 447 656 794 478 616 791 691 905 606 492 715 807 479 620 865 693 836 494 664 810 500 722 913 607 717 495 668 797 723 838 622 811 502 697 818 384 628 843 680 929 738 448 670 961 623 839 630 813 503 725 900 684 850 739 819 506 729 842 507 671 784 631 902 509 686 821 634 792 712 903 692 480 741 845 687 906 635 851 496 508 504 510 511 512 716 576 694 745 637 718 695 724 698 753 719 608 726 699 740 624 727 701 730 742 672 632 731 743 746 688 636 733 696 747 638 754 720 700 749 639 755 757 702 728 732 744 761 703 734 748 735 750 756 751 758 640 704 759 762 763 765 736 752 764 760 766 767 768 825 796 866 808 853 907 914 798 812 867 857 909 799 915 840 930 814 869 820 917 815 844 873 931 822 962 921 846 933 823 852 826 881 904 847 963 854 827 937 908 868 855 829 858 965 910 870 916 945 911 800 969 859 918 871 874 932 861 816 977 919 922 934 875 824 882 923 848 877 993 935 964 828 938 883 925 856 966 885 939 830 946 860 967 941 889 970 831 912 872 947 862 971 876 949 920 978 863 973 924 979 878 953 884 936 994 926 879 886 981 940 995 985 927 887 942 890 968 948 997 943 891 972 832 950 1001 893 974 951 980 954 1009 975 864 982 955 996 880 983 957 986 998 928 888 987 999 1002 944 892 989 952 1003 894 1010 976 956 1005 895 1011 1013 958 984 988 1000 1017 959 990 1004 991 1006 1012 1007 1014 896 960 1015 1018 1019 1021 992 1008 1020 1016 1022 1023 1024]

Sequence B = [1 257 513 2 3 5 9 17 33 4 6 65 10 7 18 11 19 129 13 34 66 21 35 25 37 8 130 67 12 41 69 131 258 20 14 49 15 73 22 133 36 27 81 38 26 23 137 39 97 68 42 145 29 70 43 50 75 161 193 71 45 132 82 51 74 16 134 53 24 135 77 138 83 57 28 98 40 85 139 146 30 44 99 89 141 31 147 72 162 46 101 52 149 47 76 105 163 54 194 153 78 165 55 84 769 58 113 136 79 195 86 59 169 140 259 100 87 61 90 197 142 102 148 177 143 32 201 91 150 103 106 261 514 164 93 48 209 151 154 166 107 265 56 114 155 80 109 225 167 196 273 60 170 115 157 88 198 117 171 289 515 62 260 178 92 199 173 121 202 63 262 144 104 179 94 203 108 181 152 321 517 210 266 95 205 156 211 110 185 263 116 274 168 226 158 111 118 213 172 267 521 227 275 217 385 159 119 174 122 269 529 200 290 180 322 229 175 123 204 64 277 545 182 291 233 281 125 206 183 212 293 516 186 264 241 386 207 96 214 187 323 518 228 268 112 297 215 325 189 218 387 577 230 276 160 270 120 305 219 231 271 522 234 329 176 278 124 389 221 292 184 283 519 235 337 530 126 294 242 282 208 279 523 188 393 237 295 353 324 127 298 531 243 401 641 245 285 190 326 299 216 306 525 220 331 546 232 417 449 327 301 249 388 578 191 338 533 222 307 330 272 236 390 547 223 309 537 280 391 333 394 238 339 549 244 313 520 284 642 354 296 341 239 395 579 246 402 524 286 300 355 345 397 128 287 553 192 403 581 328 643 418 302 357 247 308 532 405 526 303 561 332 361 419 310 250 450 527 251 409 585 334 534 421 311 340 253 314 645 369 548 392 539 335 451 342 315 425 593 396 550 356 538 343 535 317 346 453 224 398 649 358 551 404 609 433 580 399 288 240 457 554 347 657 406 541 359 362 420 349 582 304 555 465 562 407 587 410 673 422 252 363 705 312 583 370 557 411 336 365 481 644 423 594 452 563 316 586 426 528 371 413 248 344 646 454 565 373 536 427 647 318 434 589 348 650 455 595 429 569 377 458 319 400 540 360 610 435 552 350 597 459 364 651 437 658 408 542 466 556 351 611 461 601 254 412 653 770 467 543 366 659 441 584 372 674 424 558 482 613 414 564 367 374 469 661 428 559 483 588 473 617 415 675 566 375 706 430 665 378 590 456 677 567 436 596 771 485 570 431 625 379 648 460 591 320 707 438 598 489 571 381 681 652 462 612 773 439 599 468 573 442 602 709 255 497 654 777 463 614 352 660 470 689 655 544 443 713 785 484 603 368 662 615 618 471 676 801 445 605 474 560 721 663 486 666 416 678 376 619 475 568 626 487 667 772 490 592 432 621 737 679 380 708 774 477 572 833 682 627 669 440 600 778 491 710 382 629 683 574 498 690 775 464 604 786 711 685 633 444 714 779 493 575 383 656 616 691 499 606 787 501 715 897 620 693 664 446 722 781 472 607 802 717 668 723 476 622 834 488 697 789 628 680 738 505 670 803 623 793 630 725 447 684 805 478 739 776 729 671 631 492 686 898 634 835 712 692 256 479 741 780 494 687 809 635 837 716 500 576 899 694 788 745 637 495 718 782 695 817 724 783 698 502 753 841 719 790 608 726 384 699 901 740 804 624 795 727 448 701 849 730 806 742 794 503 672 791 632 905 731 807 743 506 746 865 507 688 509 480 496 508 504 510 511 512 636 733 696 747 638 754 720 700 749 639 755 757 702 728 732 744 761 703 734 748 735 750 756 751 758 640 704 759 762 763 765 736 752 764 760 766 767 768 836 810 913 797 838 811 818 843 929 961 839 813 900 850 819 842 784 902 821 792 903 845 906 851 825 796 866 808 853 907 914 798 812 867 857 909 799 915 840 930 814 869 820 917 815 844 873 931 822 962 921 846 933 823 852 826 881 904 847 963 854 827 937 908 868 855 829 858 965 910 870 916 945 911 800 969 859 918 871 874 932 861 816 977 919 922 934 875 824 882 923 848 877 993 935 964 828 938 883 925 856 966 885 939 830 946 860 967 941 889 970 831 912 872 947 862 971 876 949 920 978 863 973 924 979 878 953 884 936 994 926 879 886 981 940 995 985 927 887 942 890 968 948 997 943 891 972 832 950 1001 893 974 951 980 954 1009 975 864 982 955 996 880 983 957 986 998 928 888 987 999 1002 944 892 989 952 1003 894 1010 976 956 1005 895 1011 1013 958 984 988 1000 1017 959 990 1004 991 1006 1012 1007 1014 896 960 1015 1018 1019 1021992 1008 1020 1016 1022 1023 1024]

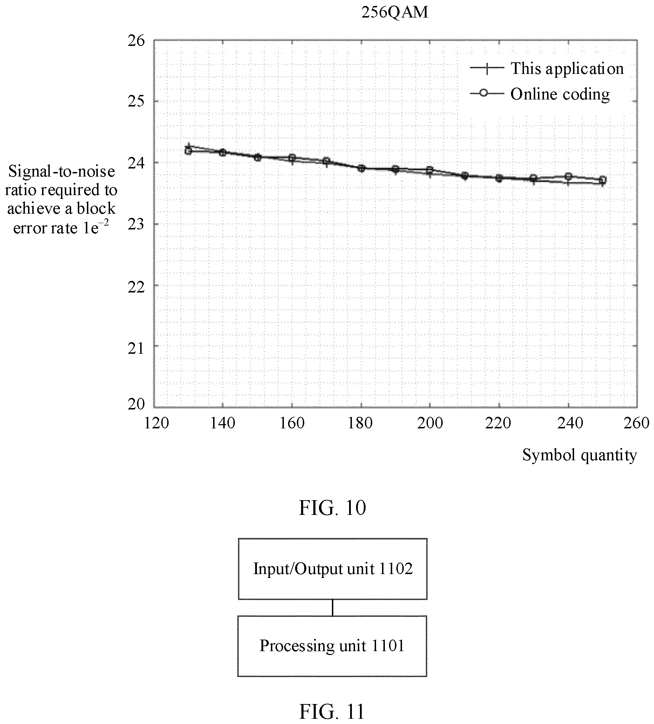

FIG. 10 shows a case in which a higher-order modulation is 256QAM. A horizontal coordinate is a symbol quantity, and a vertical coordinate is a signal-to-noise ratio required to reach a block error rate $1e^{-2}$. A dashed line is a simulation effect diagram of the solution in this application, and a solid line is a simulation effect diagram of online coding. It can be learned that performance of rate matching in this application is basically the same as that of online construction.

Based on a same concept, an embodiment of this application provides a communication apparatus, as shown in FIG. 11, including a processing unit 1101 and an input/output unit 1102. In actual application, the input/output unit may be implemented by using a same data processing chip, or may be implemented by using different data processing chips. This is not specifically limited in this application. The communication apparatus may be the foregoing sending apparatus and the foregoing receiving apparatus. It should be understood that the input/output unit may be referred to as a transceiver unit, a communication unit, or the like. When the communication apparatus is a network device, the input/output unit may be a transceiver, and the processing unit may be a processor. When the communication apparatus is a module (for example, a chip) in a network device, the input/output unit may be an input/output interface, an input/output circuit, an input/output pin, or the like, and may also be referred to as an interface, a communication interface, an interface circuit, or the like. The processing unit may be a processor, a processing circuit, a logic circuit, or the like.

When the communication apparatus is a sending apparatus, the input/output unit 1102 is configured to obtain an information bit sequence, where a length of the information bit sequence is K, and K is a positive integer. The processing unit 1101 is configured to: determine a length K1 of a first sequence based on K or M, where M is a quantity of modulation symbols, and K1 and M are positive integers; obtain a first vector based on K, K1, and a predefined sequence, where a length of the first vector is 2JM, M is the quantity of modulation symbols, J is a modulation order, M and J are positive integers, the first vector indicates J coding sub-blocks, the J coding sub-blocks separately belong to a first-type sub-block or a second-type sub-block, the first-type sub-block includes at least one coding sub-block, and the second-type sub-block includes at least one coding sub-block; determine frozen bit locations in the first-type sub-block and information bit locations in the second-type sub-block; and encode the information bit sequence based on the frozen bit locations in the first-type sub-block, the information bit locations in the second-type sub-block, and the first vector.

When the communication apparatus is a receiving apparatus, the input/output unit 1102 is configured to: obtain a to-be-decoded sequence; and determine K and M, where K is a length of an information bit sequence, and M is a quantity of modulation symbols. The processing unit 1101 is configured to: determine K1 based on K or M, where K, K1, and M are positive integers; obtain a first vector based on K, K1, and a predefined sequence, where a length of the first vector is 2JM, J is a modulation order, J is a positive integer, the first vector indicates J coding sub-blocks, the J coding sub-blocks separately belong to a first-type sub-block or a second-type sub-block, the first-type sub-block includes at least one coding sub-block, and the second-type sub-block includes at least one coding sub-block; determine frozen bit locations in the first-type sub-block and information bit locations in the second-type sub-block; and decode the to-be-decoded sequence based on the frozen bit locations in the first-type sub-block, the information bit locations in the second-type sub-block, and the first vector, to obtain the information bit sequence whose length is K.

It should be noted that the encoding method provided in this application may be applied to higher-order modulation, for example, 64 quadrature amplitude modulation (quadrature amplitude modulation, QAM), or 256QAM. The information bit sequence may be understood as a sequence that requires coding processing, or may be understood as a to-be-encoded sequence. An information bit sequence quantity length (that is, the length) is determined, and the length of the information bit sequence is K. To improve robustness and reduce complexity during encoding, the information bit sequence may be divided into the first sequence and a second sequence, and different coding processing is performed for different sequences. In actual application, if shaping is introduced during encoding, the first sequence may be understood as a sequence for shaping. Certainly, in actual application, another encoding operation (an operation different from conventional polar coding) may be introduced, and the first sequence may be a sequence for another encoding operation. This is not specifically limited in this application.

In addition, the predefined sequence may be understood as a sequence that meets a mother code length (a sequence length meets 2N, where N is a positive integer), for example, a sequence whose length is 8: [1, 2, 3, 5, 4, 6, 7, 8]; or may be understood as another sequence, for example, a sequence pre-agreed upon by the sending apparatus and the receiving apparatus. This is not specifically limited in this application.

It should be noted that, when an encoding operation is performed, a modulation scheme (for example, the modulation scheme is 64QAM higher-order modulation), the modulation order J being 3 $\mathrm{r}=\log_2(\sqrt{64})=3$ ), and the quantity M of modulation symbols (the quantity of modulation symbols may be preset, for example, agreed upon by the sending apparatus and the receiving apparatus) need to be determined, to construct the first vector whose length is 2JM based on K, K1, the predefined sequence, the modulation order, and the quantity of modulation symbols. A location of the information bit sequence corresponding to the first vector may be determined based on the first vector (for example, if the information bit sequence is [0 1 0], and the first vector is [0 0 0 0 0 1 1 1], the information bit sequence may correspond to 111 in the first vector. In this case, when an encoding operation is performed, the 6th, the 7th, and the 8th locations may be set as information bit locations, and other locations may be set as frozen bit locations). In addition, the information bit locations and the frozen bit locations may be determined by using the first vector, and an encoding operation may be efficiently performed based on the obtained frozen bit locations and the obtained information bit locations.

In addition, the first vector may indicate the J coding sub-blocks, the J coding sub-blocks separately belong to the first-type sub-block or the second-type sub-block, the first-type sub-block includes at least one coding sub-block, and the second-type sub-block may include at least one coding sub-block. Because another encoding operation such as a shaping operation may be introduced during encoding, the first-type sub-block may be understood as a shaping sub-block. To ensure that a decoder, that is, the receiving apparatus, can more quickly obtain the information bit sequence through decoding when another encoding operation is introduced, the information bit sequence may be encoded based on the frozen bit locations in the first-type sub-block, the information bit locations in the second-type frozen bit, and the first vector, to improve decoding efficiency of the decoder.

When an encoding operation is performed in this application, a solution (that is, online coding) of adjusting a coding policy based on a channel status is not used. Instead, the first vector is constructed based on the length of the information bit sequence, the length of the first sequence, and the predefined sequence, different coding sub-blocks are indicated based on the first vector, and the information bit sequence is encoded based on information bit locations and frozen bit locations in the different coding sub-blocks and the first vector. In this way, encoding efficiency can be improved, and calculation complexity is reduced compared with online coding.

In an optional implementation, the processing unit 1101 is specifically configured to: determine a first index set $\Theta$ based on K, K1, and the predefined sequence, and obtain the first vector based on the first index set $\Theta$, where a location index i in the first vector satisfies: if $i \in \Theta$, the location i carries a first preset value; and if $i \notin \Theta$, the location i carries a second preset value, where the first preset value is different from the second preset value, $1 \le i \le 2JM$, and i is a positive integer. After the first index set is determined based on K, K1, and the predefined sequence, the first vector is obtained based on the first index set. In this way, information bit locations and check bit locations can be directly obtained, thereby reducing coding construction complexity.

In an optional implementation, the first preset value is 1, and the second preset value is 0; or the first preset value is 0, and the second preset value is 1. This is not specifically limited herein in this application. Usually, the first preset value indicates a location of the information bit sequence.

In an optional implementation, an element carried at a $(2M(y - 1) + 1)^{th}$ location in the first vector to an element carried at a $(2My)^{th}$ location in the first vector correspond to a $y^{th}$ coding sub-block, $1 \leq y \leq J$, and $y$ is a positive integer. In other words, lengths of the coding sub-blocks indicated by the first vector are all 2M.

In an optional implementation, the processing unit 1101 is further configured to: select F information bit locations from the information bit locations in the second-type sub-block, where F is a length of frozen bits in the first-type sub-block, and F is an integer; and assign values of the F frozen bit locations in the first-type sub-block to the F information bit locations in the second-type sub-block.

It should be noted that, assigning the values of the F frozen bits in the first-type sub-block to the F information bit locations in the second-type sub-block may be understood as directly duplicating the values of the F frozen bits in the first-type sub-block to the information bit locations in the second-type sub-block, or may be understood as assigning the values of the F frozen bits in the first-type sub-block to the information bit locations in the second-type sub-block through encoding (scrambling, exclusive OR, or the like). In actual application, a value assignment manner is not specifically limited in this application.

In addition, in actual application, the length of the frozen bits in the first-type sub-block may alternatively be F1 (if a length of all frozen bits in the first-type sub-block is 5, F1 may be 3 or another value less than 5), and F2 information bit locations may be selected from the information bit locations in the second-type sub-block. A value of F2 may be different from that of F1. This is not specifically limited herein in this application, provided that a relationship between the frozen bits of the first-type sub-block and information bits of the second-type sub-block may be determined. The relationship between the frozen bits of the first-type sub-block and the second-type information bits is determined, to help the receiving apparatus perform decoding more quickly.

In an optional implementation, the processing unit 1101 of the sending apparatus is further configured to: perform shaping mapping and polar transform on the first sequence to obtain a third sequence; extract a fourth sequence from the third sequence based on the first vector, where an element in the fourth sequence is a value of an information bit location in the first-type sub-block, and a length of the fourth sequence is less than a length of the third sequence; perform cyclic redundancy check CRC calculation on a fifth sequence to obtain a sixth sequence, where the fifth sequence includes a second sequence and the fourth sequence; and encode the sixth sequence. It should be noted that, decoding performance can be improved by introducing CRC.

In an optional implementation, K1 is determined in the following manner:

> manner 1: determining K1 based on an index value corresponding to K or M; or
> manner 2:
>
> determining K1 by using the following formula:

$$K1 = \log_2 C_{2M}^{\lfloor 2Mp_{bias} \rfloor},$$

> where
>
> K1 represents a length of the first sequence; M represents a quantity of modulation symbols; and $p_{bias}$ represents a preset shaping probability.

It should be noted that, determining K1 in the manner 1 is simpler, and has a smaller calculation amount. In the manner 2, K1 is determined based on the quantity of modulation symbols and the preset shaping probability. Compared with the manner 1, in the manner 2, a calculation amount is increased, but reliability is higher and flexibility is higher.

In an optional implementation, the processing unit 1101 is specifically configured to: determine a first parameter T based on K and K1, and select T sequence elements from the predefined sequence to construct the first index set Θ. In this way, the first index set can be quickly determined, so that the first vector can be more quickly determined based on the first index set.

In an optional implementation, T is determined in the following manner:

> manner 1:

$$T = 2M + K - K1,$$

where

T represents the first parameter, M represents the quantity of modulation symbols, K represents the length of the information bit sequence, and K1 represents the length of the first sequence; or

manner 2:

the first parameter is further related to a CRC length, and T is determined by using the following formula:

$$T = 2M + K + L - K1,$$

where

T represents the first parameter, M represents the quantity of modulation symbols, K represents the length of the information bit sequence, K1 represents the length of the first sequence, and L represents the CRC length.

The first parameter determined in the foregoing two manners is more reliable, so that coding efficiency is improved during coding, and coding complexity is reduced. In addition, it should be further noted that the first sequence may be a plurality of bits, and there may also be a plurality of first-type sub-block. Assuming that the first sequence is q sub-sequences, when the first parameter is related to the CRC length, the first parameter may be determined by referring to the following formula:

$$T = 2qM + K + L - \sum_{x=1}^{q} K_{x,1},$$

where

T represents the first parameter, M represents the quantity of modulation symbols, K represents the length of the information bit sequence, q represents a quantity of sub-sequences of the first sequence, K1 represents the length of the first sequence, L represents the CRC length, and $K_{x,1}$ represents a length of an $x^{th}$ sub-sequence.

In an optional implementation, the processing unit 1101 is specifically configured to:

select T sequence elements from the predefined sequence as the first index set according to a first rule, where the first rule includes one of the following: selecting T sequence elements forward from the last sequence element of the predefined sequence as the first index set, and selecting T sequence elements backward from the $1^{st}$ sequence element of the predefined sequence as the first index set.

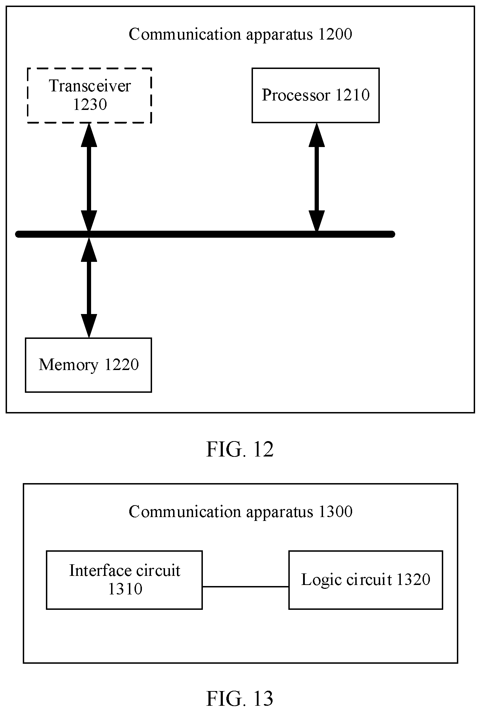

In addition, FIG. 12 shows a communication apparatus 1200 further provided in this application. For example, the communication apparatus 1200 may be a chip or a chip system. Optionally, in this embodiment of this application, the chip system may include a chip, or may include the chip and another discrete device.

The communication apparatus 1200 may include at least one processor 1210, and the communication apparatus 1200 may further include at least one memory 1220, configured to store a computer program, program instructions, and/or data. The memory 1220 is coupled to the processor 1210. The coupling in this embodiment of this application may be an indirect coupling or a communication connection between apparatuses, units, or modules in an electrical form, a mechanical form, or another form, and is used for information exchange between the apparatuses, the units, or the modules. The processor 1210 may perform a cooperative operation with the memory 1220. The processor 1210 may execute the computer program stored in the memory 1220. Optionally, the at least one memory 1220 may also be integrated with the processor 1210.

Optionally, in actual application, the communication apparatus 1200 may include or may not include a transceiver 1230. A dashed box is used as an example in the figure. The communication apparatus 1200 may exchange information with another device via the transceiver 1230. The transceiver 1230 may be a circuit, a bus, a transceiver, or any other apparatus that may be configured to exchange information.

In a possible implementation, the communication apparatus 1200 may be applied to the foregoing terminal device, or may be the foregoing first communication apparatus, or may be the foregoing second communication apparatus. The memory 1220 stores a computer program, program instructions, and/or data necessary for implementing a function of a relay device in any one of the foregoing embodiments. The processor 1210 may execute the computer program stored in the memory 1220, to complete the method in any one of the foregoing embodiments.

A specific connection medium between the transceiver 1230, the processor 1210, and the memory 1220 is not limited in this embodiment of this application. In this embodiment of this application, the memory 1220, the processor 1210, and the transceiver 1230 are connected through a bus in FIG. 12. The bus is represented by using a thick line in FIG. 12. A manner of a connection between other components is merely an example for description, and is not limited thereto. The bus may be classified into an address bus, a data bus, a control bus, and the like. For ease of representation, only one bold line is used to indicate the bus in FIG. 12, but this does not mean that there is only one bus or only one type of bus. In embodiments of this application, the processor may be a general-purpose processor, a digital signal processor, an application-specific integrated circuit, a field programmable gate array or another programmable logic device, a discrete gate or transistor logic device, or a discrete hardware component, and may implement or perform the methods, steps, and logical block diagrams disclosed in embodiments of this application. The general-purpose processor may be a microprocessor or any conventional processor or the like. The steps of the method disclosed with reference to embodiments of this application may be directly performed by a hardware processor, or may be performed by using a combination of hardware in the processor and a software module.

In embodiments of this application, the memory may be a nonvolatile memory, a hard disk drive (hard disk drive, HDD) or a solid-state drive (solid-state drive, SSD), or may be a volatile memory (volatile memory), for example, a random access memory (random access memory, RAM). The memory may alternatively be any other medium that can be configured to carry or store expected program code in a form of instructions or a data structure and that can be accessed by a computer. This is not limited thereto. The memory in the embodiment of this application may alternatively be a circuit or any other apparatus that can implement a storage function, and is configured to store the computer program, the program instruction, and/or the data.

Based on the foregoing embodiments, refer to FIG. 13. An embodiment of this application further provides another communication apparatus 1300, including an interface circuit 1310 and a logic circuit 1320. The interface circuit 1310 may be understood as an input/output interface, and may be configured to perform operation steps the same as those of the input/output unit shown in FIG. 11 or the transceiver shown in FIG. 12. Details are not described herein again in this application. The logic circuit 1320 may be configured to run code instructions to perform the method in any one of the foregoing embodiments, may be understood as the processing unit in FIG. 11 or the processor in FIG. 12, and may implement a same function as the processing unit or the processor. Details are not described herein again in this application.

Based on the foregoing embodiments, an embodiment of this application further provides a readable storage medium. The readable storage medium stores instructions. When the instructions are executed, the encoding method and the decoding method in any one of the foregoing embodiments are implemented. The readable storage medium may include any medium that can store program code, such as a USB flash drive, a removable hard disk, a read-only memory, a random access memory, a magnetic disk, or a compact disc.

A person skilled in the art should understand that embodiments of this application may be provided as a method, a system, or a computer program product. Therefore, this application may use a form of hardware only embodiments, software only embodiments, or embodiments with a combination of software and hardware. In addition, this application may use a form of a computer program product that is implemented on one or more computer-usable storage media (including but not limited to a disk memory, a CD-ROM, an optical memory, and the like) that include computer-usable program code.

This application is described with reference to the flowcharts and/or block diagrams of the method, the apparatus (system), and the computer program product according to this application. It should be understood that computer program instructions may be used to implement each process and/or each block in the flowcharts and/or the block diagrams and a combination of a process and/or a block in the flowcharts and/or the block diagrams. These computer program instructions may be provided to a general-purpose computer, a dedicated computer, an embedded processor, or a processor of another programmable data processing apparatus to generate a machine, so that the instructions executed by the computer or the processor of the another programmable data processing apparatus generate an apparatus for implementing a function specified in one or more processes in the flowcharts and/or in one or more blocks in the block diagrams.

These computer program instructions may be alternatively stored in a computer-readable memory that can instruct a computer or another programmable data processing apparatus to work in a specific manner, so that the instructions stored in the computer-readable memory generate an artifact that includes an instruction apparatus. The instruction apparatus implements a function specified in one or more processes in the flowcharts and/or in one or more blocks in the block diagrams.

These computer program instructions may be alternatively loaded onto a computer or another programmable data processing apparatus, so that a series of operations and steps are performed on the computer or the another programmable apparatus, to generate computer-implemented processing. Therefore, the instructions executed on the computer or the another programmable apparatus provide steps for implementing a function specified in one or more processes in the flowcharts and/or in one or more blocks in the block diagrams.

**Claims**

1. An encoding method, comprising:

   obtaining an information bit sequence, wherein a length of the information bit sequence is K, and K is a positive integer;
   determining a length K1 of a first sequence based on K or M, wherein M is a quantity of modulation symbols, and K1 and M are positive integers;
   obtaining a first vector based on K, K1, and a predefined sequence, wherein a length of the first vector is 2JM, M is the quantity of modulation symbols, J is a modulation order, M and J are positive integers, the first vector indicates J coding sub-blocks, the J coding sub-blocks separately belong to a first-type sub-block or a second-type sub-block, the first-type sub-block comprises at least one coding sub-block, and the second-type sub-block comprises at least one coding sub-block;
   determining frozen bit locations in the first-type sub-block and information bit locations in the second-type sub-block; and
   encoding the information bit sequence based on the frozen bit locations in the first-type sub-block, the information bit locations in the second-type sub-block, and the first vector.

2. The method according to claim 1, wherein the obtaining a first vector based on K, K1, and a predefined sequence comprises:

   determining a first index set $\Theta$ based on K, K1, and the predefined sequence; and
   obtaining the first vector based on the first index set $\Theta$, wherein a location index i in the first vector satisfies:

   if $i \in \Theta$, the location i carries a first preset value; and
   if $i \notin \Theta$, the location i carries a second preset value, wherein the first preset value is different from the second preset value, $1 \le i \le 2JM$, and i is a positive integer.

3. The method according to claim 1 or 2, wherein an element carried at a $(2M(y - 1) + 1)^{th}$ location in the first vector to an element carried at a $(2My)^{th}$ location in the first vector correspond to a $y^{th}$ coding sub-block, $1 \le y \le J$, and y is a positive integer.

4. The method according to any one of claims 1 to 3, further comprising:

   selecting F information bit locations from the information bit locations in the second-type sub-block, wherein F is a length of frozen bits in the first-type sub-block, and F is an integer; and
   assigning values of the F frozen bit locations in the first-type sub-block to the F information bit locations in the second-type sub-block.

5. The method according to any one of claims 1 to 4, wherein the encoding the information bit sequence based on the frozen bit locations in the first-type sub-block, the information bit locations in the second-type sub-block, and the first vector further comprises:

   performing shaping mapping and polar transform on the first sequence to obtain a third sequence;
   extracting a fourth sequence from the third sequence based on the first vector, wherein an element in the fourth sequence is a value of an information bit location in the first-type sub-block, and a length of the fourth sequence is less than a length of the third sequence;
   performing cyclic redundancy check CRC calculation on a fifth sequence to obtain a sixth sequence, wherein the fifth sequence comprises a second sequence and the fourth sequence; and
   encoding the sixth sequence and the second sequence.

6. The method according to any one of claims 1 to 5, wherein K1 is determined in the following manner:

   manner 1:
   determining K1 based on an index value corresponding to K or M; or
   manner 2:

   determining K1 by using the following formula:

$$K1 = \left\lfloor \log_2 C_{2M}^{\lfloor 2Mp_{bias} \rfloor} \right\rfloor,$$

wherein
K1 represents the length of the first sequence, M represents the quantity of modulation symbols, and $p_{bias}$ represents a preset shaping probability.

7. The method according to any one of claims 2 to 6, wherein the determining a first index set Θ based on K, K1, and the predefined sequence comprises:

determining a first parameter T based on K and K1; and
selecting T sequence elements from the predefined sequence to construct the first index set Θ.

8. The method according to claim 7, wherein T is determined in the following manner:

manner 1:

$$T = 2M + K - K1,$$

wherein
T represents the first parameter, M represents the quantity of modulation symbols, K represents the length of the information bit sequence, and K1 represents the length of the first sequence; or
manner 2:

the first parameter is further related to a CRC length, and T is determined by using the following formula:

$$T = 2M + K + L - K1,$$

wherein
T represents the first parameter, M represents the quantity of modulation symbols, K represents the length of the information bit sequence, K1 represents the length of the first sequence, and L represents the CRC length.

9. The method according to claim 7 or 8, wherein the selecting T sequence elements from the predefined sequence to construct the first index set comprises:
selecting T sequence elements from the predefined sequence as the first index set according to a first rule, wherein the first rule comprises one of the following: selecting T sequence elements forward from the last sequence element of the predefined sequence as the first index set, and selecting T sequence elements backward from the 1st sequence element of the predefined sequence as the first index set.

10. The method according to any one of claims 2 to 9, wherein the first preset value is 1, and the second preset value is 0; or the first preset value is 0, and the second preset value is 1.

11. A decoding method, comprising:

obtaining a to-be-decoded sequence;
determining K and M, wherein K is a length of an information bit sequence, and M is a quantity of modulation symbols;
determining K1 based on K or M, wherein K, K1, and M are positive integers;
obtaining a first vector based on K, K1, and a predefined sequence, wherein a length of the first vector is 2JM, J is a modulation order, J is a positive integer, the first vector indicates J coding sub-blocks, the J coding sub-blocks separately belong to a first-type sub-block or a second-type sub-block, the first-type sub-block comprises at least one coding sub-block, and the second-type sub-block comprises at least one coding sub-block;
determining frozen bit locations in the first-type sub-block and information bit locations in the second-type sub-block; and

decoding the to-be-decoded sequence based on the frozen bit locations in the first-type sub-block, the information bit locations in the second-type sub-block, and the first vector, to obtain the information bit sequence whose length is K.

**12.** The method according to claim 11, wherein the obtaining a first vector based on K, K1, and a predefined sequence comprises:

determining a first index set $\Theta$ based on K, K1, and the predefined sequence; and
obtaining the first vector based on the first index set $\theta$, wherein a location index i in the first vector satisfies:

if $i \in \Theta$, the location i carries a first preset value; and
if $i \notin \Theta$, the location i carries a second preset value, wherein the first preset value is different from the second preset value, $1 \leq i \leq 2JM$, and i is a positive integer.

**13.** The method according to claim 11 or 12, wherein an element carried at a $(2M(y - 1) + 1)^{th}$ location in the first vector to an element carried at a $(2My)^{th}$ location in the first vector correspond to a $y^{th}$ coding sub-block, $1 \leq y \leq J$, and y is a positive integer.

**14.** The method according to any one of claims 11 to 13, further comprising:

selecting F information bit locations from the information bit locations in the second-type sub-block, wherein F is a length of frozen bits in the first-type sub-block, and F is an integer; and
assigning values of the F frozen bit locations in the first-type sub-block to the F information bit locations in the second-type sub-block.

**15.** The method according to any one of claims 11 to 14, wherein K1 is determined in the following manner:

manner 1:
determining K1 based on an index value corresponding to K or M; or
manner 2:

determining K1 by using the following formula:

$$K1 = \left\lfloor \log_2 C_{2M}^{\lfloor 2Mp_{bias} \rfloor} \right\rfloor,$$

wherein
K1 represents a length of a first sequence, M represents the quantity of modulation symbols, and $p_{bias}$ represents a preset shaping probability.

**16.** The method according to any one of claims 12 to 15, wherein the determining a first index set $\Theta$ based on K, K1, and the predefined sequence comprises:

determining a first parameter $T$ based on K and K1; and
selecting T sequence elements from the predefined sequence to construct the first index set $\Theta$.

**17.** The method according to claim 16, wherein T is determined in the following manner:

manner 1:

$$T = 2M + K - K1,$$

wherein T represents the first parameter, M represents the quantity of modulation symbols, K represents the length of the information bit sequence, and K1 represents the length of the first sequence; or
manner 2:

the first parameter is further related to a CRC length, and T is determined by using the following formula:

$$T = 2M + K + L - K1,$$

wherein

T represents the first parameter, M represents the quantity of modulation symbols, K represents the length of the information bit sequence, K1 represents the length of the first sequence, and L represents the CRC length.

18. The method according to claim 16 or 17, wherein the selecting T sequence elements from the predefined sequence to construct the first index set comprises:

selecting T sequence elements from the predefined sequence as the first index set according to a first rule, wherein the first rule comprises one of the following: selecting T sequence elements forward from the last sequence element of the predefined sequence as the first index set, and selecting T sequence elements backward from the 1st sequence element of the predefined sequence as the first index set.

19. The method according to any one of claims 12 to 18, wherein the first preset value is 1, and the second preset value is 0; or the first preset value is 0, and the second preset value is 1.

20. A communication apparatus, comprising:

an input/output unit, configured to obtain an information bit sequence, wherein a length of the information bit sequence is K, and K is a positive integer; and

a processing unit, configured to: determine a length K1 of a first sequence based on K or M, wherein M is a quantity of modulation symbols, and K1 and M are positive integers; obtain a first vector based on K, K1, and a predefined sequence, wherein a length of the first vector is 2JM, M is the quantity of modulation symbols, J is a modulation order, M and J are positive integers, the first vector indicates J coding sub-blocks, the J coding sub-blocks separately belong to a first-type sub-block or a second-type sub-block, the first-type sub-block comprises at least one coding sub-block, and the second-type sub-block comprises at least one coding sub-block; determine frozen bit locations in the first-type sub-block and information bit locations in the second-type sub-block; and encode the information bit sequence based on the frozen bit locations in the first-type sub-block, the information bit locations in the second-type sub-block, and the first vector.

21. The apparatus according to claim 20, wherein the processing unit is specifically configured to:

determine a first index set $\Theta$ based on K, K1, and the predefined sequence; and

obtain the first vector based on the first index set $\Theta$, wherein a location index i in the first vector satisfies:

if $i \in \Theta$, the location i carries a first preset value; and

if $i \notin \Theta$, the location i carries a second preset value, wherein the first preset value is different from the second preset value, $1 \le i \le 2JM$, and i is a positive integer.

22. The apparatus according to claim 20 or 21, wherein an element carried at a $(2M(y - 1) + 1)^{th}$ location in the first vector to an element carried at a $(2My)^{th}$ location in the first vector correspond to a $y^{th}$ coding sub-block, $1 \le y \le J$, andy is a positive integer.

23. The apparatus according to any one of claims 20 to 22, wherein the processing unit is further configured to:

select F information bit locations from the information bit locations in the second-type sub-block, wherein F is a length of frozen bits in the first-type sub-block, and F is an integer; and

assign values of the F frozen bit locations in the first-type sub-block to the F information bit locations in the second-type sub-block.

24. The apparatus according to any one of claims 20 to 23, wherein the processing unit is further configured to:

perform shaping mapping and polar transform on the first sequence to obtain a third sequence;

extract a fourth sequence from the third sequence based on the first vector, wherein an element in the fourth sequence is a value of an information bit location in the first-type sub-block, and a length of the fourth sequence is less than a length of the third sequence;
perform cyclic redundancy check CRC calculation on a fifth sequence to obtain a sixth sequence, wherein the fifth sequence comprises a second sequence and the fourth sequence; and
encode the sixth sequence.

**25.** The apparatus according to any one of claims 20 to 24, wherein K1 is determined in the following manner:

manner 1:
determining K1 based on an index value corresponding to K or M; or
manner 2:

determining K1 by using the following formula:

$$K1 = \left\lfloor \log_2 C_{2M}^{\lfloor 2Mp_{bias} \rfloor} \right\rfloor,$$

wherein
K1 represents the length of the first sequence, M represents the quantity of modulation symbols, and $p_{bias}$ represents a preset shaping probability.

**26.** The apparatus according to any one of claims 21 to 25, wherein the processing unit is specifically configured to:

determine a first parameter T based on K and K1; and
select T sequence elements from the predefined sequence to construct the first index set $\Theta$.

**27.** The apparatus according to claim 26, wherein T is determined in the following manner:

manner 1:

$$T = 2M + K - K1,$$

wherein
T represents the first parameter, M represents the quantity of modulation symbols, K represents the length of the information bit sequence, and K1 represents the length of the first sequence; or
manner 2:

the first parameter is further related to a CRC length, and T is determined by using the following formula:

$$T = 2M + K + L - K1,$$

wherein
T represents the first parameter, M represents the quantity of modulation symbols, K represents the length of the information bit sequence, K1 represents the length of the first sequence, and L represents the CRC length.

**28.** The apparatus according to claim 26 or 27, wherein the processing unit is specifically configured to:
select T sequence elements from the predefined sequence as the first index set according to a first rule, wherein the first rule comprises one of the following: selecting T sequence elements forward from the last sequence element of the predefined sequence as the first index set, and selecting T sequence elements backward from the 1st sequence element of the predefined sequence as the first index set.

**29.** The apparatus according to any one of claims 21 to 28, wherein the first preset value is 1, and the second preset value is 0; or the first preset value is 0, and the second preset value is 1.

**30.** A communication apparatus, comprising:

an input/output unit, configured to: obtain a to-be-decoded sequence; and determine K and M, wherein K is a length of an information bit sequence, and M is a quantity of modulation symbols; and

a processing unit, configured to: determine K1 based on K or M, wherein K, K1, and M are positive integers; obtain a first vector based on K, K1, and a predefined sequence, wherein a length of the first vector is 2JM, J is a modulation order, J is a positive integer, the first vector indicates J coding sub-blocks, the J coding sub-blocks separately belong to a first-type sub-block or a second-type sub-block, the first-type sub-block comprises at least one coding sub-block, and the second-type sub-block comprises at least one coding sub-block; determine frozen bit locations in the first-type sub-block and information bit locations in the second-type sub-block; and decode the to-be-decoded sequence based on the frozen bit locations in the first-type sub-block, the information bit locations in the second-type sub-block, and the first vector, to obtain the information bit sequence whose length is K.

**31.** The apparatus according to claim 30, wherein the processing unit is specifically configured to:

determine a first index set $\Theta$ based on K, K1, and the predefined sequence; and
obtain the first vector based on the first index set $\Theta$, wherein a location index i in the first vector satisfies:

if $i \in \Theta$, the location i carries a first preset value; and
if $i \notin \Theta$, the location i carries a second preset value, wherein the first preset value is different from the second preset value, $1 \le i \le 2JM,$ and i is a positive integer.

**32.** The apparatus according to claim 30 or 31, wherein an element carried at a $(2M(y - 1) + 1)^{\text{th}}$ location in the first vector to an element carried at a $(2My)^{\text{th}}$ location in the first vector correspond to a $y^{\text{th}}$ coding sub-block, $1 \le y \le J,$ and y is a positive integer.

**33.** The apparatus according to any one of claims 30 to 32, wherein the processing unit is further configured to:

select F information bit locations from the information bit locations in the second-type sub-block, wherein F is a length of frozen bits in the first-type sub-block, and F is an integer; and
assign values of the F frozen bit locations in the first-type sub-block to the F information bit locations in the second-type sub-block.

**34.** The apparatus according to any one of claims 30 to 33, wherein K1 is determined in the following manner:

manner 1:
determining K1 based on an index value corresponding to K or M; or
manner 2:

determining K1 by using the following formula:

$$K1 = \left\lfloor \log_2 C_{2M}^{\lfloor 2Mp_{bias} \rfloor} \right\rfloor,$$

wherein
K1 represents a length of a first sequence, M represents the quantity of modulation symbols, and $p_{bias}$ represents a preset shaping probability.

**35.** The apparatus according to any one of claims 31 to 34, wherein the processing unit is specifically configured to:

determine a first parameter T based on K and K1; and
select T sequence elements from the predefined sequence to construct the first index set $\Theta$.

**36.** The apparatus according to claim 35, wherein T is determined in the following manner:

manner 1:

$$T = 2M + K - K1,$$

wherein
T represents the first parameter, M represents the quantity of modulation symbols, K represents the length of the information bit sequence, and K1 represents the length of the first sequence; or
manner 2:

the first parameter is further related to a CRC length, and T is determined by using the following formula:

$$T = 2M + K + L - K1,$$

wherein
T represents the first parameter, M represents the quantity of modulation symbols, K represents the length of the information bit sequence, K1 represents the length of the first sequence, and L represents the CRC length.

37. The apparatus according to claim 35 or 36, wherein the processing unit is specifically configured to:
select T sequence elements from the predefined sequence as the first index set according to a first rule, wherein the first rule comprises one of the following: selecting T sequence elements forward from the last sequence element of the predefined sequence as the first index set, and selecting T sequence elements backward from the 1st sequence element of the predefined sequence as the first index set.

38. The apparatus according to any one of claims 31 to 37, wherein the first preset value is 1, and the second preset value is 0; or the first preset value is 0, and the second preset value is 1.

39. A communication apparatus, comprising at least one processor and a memory, wherein

the memory is configured to store a computer program or instructions; and
the at least one processor is configured to execute the computer program or instructions, so that the method according to any one of claims 1 to 10 or any one of claims 11 to 19 is performed.

40. A communication apparatus, comprising a logic circuit and an interface circuit, wherein

the interface circuit is configured to receive an information bit sequence or output an encoded sequence; and
the logic circuit is configured to perform the method according to any one of claims 1 to 10 or any one of claims 11 to 19.

41. A computer-readable storage medium, wherein the computer-readable storage medium stores instructions; and when the instructions are executed by a computer, the method according to any one of claims 1 to 10 or any one of claims 11 to 19 is performed.

42. A computer program product, wherein the computer program product comprises a computer program or instructions; and when the computer program or the instructions are run on a computer, the method according to any one of claims 1 to 10 or any one of claims 11 to 19 is performed.

43. A communication system, comprising a sending apparatus configured to perform the method according to any one of claims 1 to 10 and a receiving apparatus configured to perform the method according to any one of claims 11 to 19; or comprising the communication apparatus according to any one of claims 20 to 29 and the communication apparatus according to any one of claims 30 to 38.

**100**

FIG. 1

| Source | → | Source encoding | → | Channel encoding | → | Modulation |

Modulation symbol

| Sink | → | Source recovery | → | Channel decoding | → | Demodulation |

FIG. 2

FIG. 3

| Sending apparatus | Receiving apparatus |
|---|---|

Step 401: The sending apparatus obtains an information bit sequence, where a length of the information bit sequence is K, and K is a positive integer

Step 402: The sending apparatus determines a length K1 of a first sequence based on K or M, where M is a quantity of modulation symbols, and K1 and M are positive integers

Step 403: The sending apparatus obtains a first vector based on K, K1, and a predefined sequence, where a length of the first vector is 2JM, M is the quantity of modulation symbols, J is a modulation order, M and J are positive integers, the first vector indicates J coding sub-blocks, the J coding sub-blocks separately belong to a first-type sub-block or a second-type sub-block, the first-type sub-block includes at least one coding sub-block, and the second-type sub-block includes at least one coding sub-block

Step 404: The sending apparatus determines frozen bit locations in the first-type sub-block and information bit locations in the second-type sub-block

Step 405: The sending apparatus encodes the information bit sequence based on the frozen bit locations in the first-type sub-block, the information bit locations in the second-type sub-block, and the first vector

Step 406: The receiving apparatus obtains a to-be-decoded sequence

Step 407: The receiving apparatus determines K and M

Step 408: The receiving apparatus determines K1 based on K or M

Step 409: The sending apparatus obtains a first vector based on K, K1, and a predefined sequence

Step 410: The sending apparatus determines frozen bit locations in a first-type sub-block and information bit locations in a second-type sub-block

Step 411: The sending apparatus decodes the information bit sequence based on the frozen bit locations in the first-type sub-block, the information bit locations in the second-type sub-block, and the first vector, to obtain the information bit sequence whose length is K

FIG. 4

FIG. 5

FIG. 6

FIG. 7

FIG. 8

256QAM

Throughput

Signal-to-noise ratio required to achieve
a block error rate $1e^{-2}$

FIG. 9

256QAM

FIG. 10

FIG. 11

Communication apparatus 1200

Transceiver
1230

Processor 1210

Memory 1220

FIG. 12

Communication apparatus 1300

Interface circuit
1310

Logic circuit 1320

FIG. 13

## INTERNATIONAL SEARCH REPORT

International application No.

**PCT/CN2022/112907**

### A. CLASSIFICATION OF SUBJECT MATTER

H04L 1/00(2006.01)i

According to International Patent Classification (IPC) or to both national classification and IPC

### B. FIELDS SEARCHED

Minimum documentation searched (classification system followed by classification symbols)

H04L; G06F

Documentation searched other than minimum documentation to the extent that such documents are included in the fields searched

Electronic data base consulted during the international search (name of data base and, where practicable, search terms used)

CNPAT, CNKI, WPI, EPODOC: 编码, 译码, 解码, 长度, 极化码, 调制, 向量, 冻结比特, 位置, encoding, coding, decoding, length, polar, modulation, vector, frozen bits, position

### C. DOCUMENTS CONSIDERED TO BE RELEVANT

| Category* | Citation of document, with indication, where appropriate, of the relevant passages | Relevant to claim No. |
|---|---|---|
| A | CN 110495106 A (HUAWEI TECHNOLOGIES DUESSELDORF GMBH et al.) 22 November 2019 (2019-11-22)<br>  description, paragraphs 0009-0042 | 1-43 |
| A | WO 2020108771 A1 (HUAWEI TECHNOLOGIES CO., LTD. et al.) 04 June 2020 (2020-06-04)<br>  entire document | 1-43 |
| A | US 2020322090 A1 (HUAWEI TECHNOLOGIES CO., LTD.) 08 October 2020 (2020-10-08)<br>  entire document | 1-43 |
| A | US 2019393897 A1 (MITSUBISHI ELECTRIC CORPORATION) 26 December 2019 (2019-12-26)<br>  entire document | 1-43 |
| A | US 2020204197 A1 (ACCELERCOMM LIMITED et al.) 25 June 2020 (2020-06-25)<br>  entire document | 1-43 |

☐ Further documents are listed in the continuation of Box C.   ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **26 October 2022** | **17 November 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/112907**

| Patent document cited in search report | | | Publication date (day/month/year) | Patent family member(s) | | | Publication date (day/month/year) |
|---|---|---|---|---|---|---|---|
| CN | 110495106 | A | 22 November 2019 | US | 2020052718 | A1 | 13 February 2020 |
| | | | | EP | 3602796 | A1 | 05 February 2020 |
| | | | | WO | 2018192640 | A1 | 25 October 2018 |
| | | | | IN | 201937044237 | A | 15 May 2020 |
| WO | 2020108771 | A1 | 04 June 2020 | None | | | |
| US | 2020322090 | A1 | 08 October 2020 | EP | 3720020 | A1 | 07 October 2020 |
| | | | | WO | 2019128707 | A1 | 04 July 2019 |
| | | | | CN | 109962753 | A | 02 July 2019 |
| US | 2019393897 | A1 | 26 December 2019 | JP | 2019534651 | A | 28 November 2019 |
| | | | | EP | 3376672 | A1 | 19 September 2018 |
| | | | | WO | 2018169025 | A1 | 20 September 2018 |
| | | | | CN | 110383697 | A | 25 October 2019 |
| US | 2020204197 | A1 | 25 June 2020 | WO | 2019011555 | A1 | 17 January 2019 |
| | | | | CN | 110999095 | A | 10 April 2020 |
| | | | | KR | 20200066606 | A | 10 June 2020 |
| | | | | GB | 201711055 | D0 | 23 August 2017 |
| | | | | EP | 3649738 | A1 | 13 May 2020 |
| | | | | CA | 3069482 | A1 | 17 January 2019 |
| | | | | AU | 2018300569 | A1 | 13 February 2020 |
| | | | | GB | 201714559 | D0 | 25 October 2017 |
| | | | | JP | 2020532927 | A | 12 November 2020 |
| | | | | US | 2021242886 | A1 | 05 August 2021 |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 202110971999

### Non-patent literature cited in the description

- **T. V RAMABADRAN ; S. S. GAITONDE.** A tutorial on CRC computations. *IEEE Micro,* August 1988, vol. 8 (4), 62-75